(19) Europäisches Patentamt
European Patent Office
Office européen des brevets

(11) **EP 4 580 072 A1**

(12) **EUROPEAN PATENT APPLICATION**
published in accordance with Art. 153(4) EPC

(43) Date of publication:
**02.07.2025 Bulletin 2025/27**

(51) International Patent Classification (IPC):
**H04B 1/04** (2006.01)

(21) Application number: **23867495.6**

(52) Cooperative Patent Classification (CPC):
**H04B 1/04**

(22) Date of filing: **19.09.2023**

(86) International application number:
**PCT/CN2023/119680**

(87) International publication number:
**WO 2024/061208 (28.03.2024 Gazette 2024/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.09.2022 CN 202211168582**

(71) Applicant: **Huawei Technologies Co., Ltd.
Shenzhen, Guangdong 518129 (CN)**

(72) Inventors:
• **PENG, Zhongchong
Shenzhen, Guangdong 518129 (CN)**
• **LIU, Fengwei
Shenzhen, Guangdong 518129 (CN)**
• **CHEN, Lei
Shenzhen, Guangdong 518129 (CN)**

(74) Representative: **Isarpatent
Patent- und Rechtsanwälte
Barth Hassa Peckmann & Partner mbB
Friedrichstraße 31
80801 München (DE)**

(54) **COMMUNICATION METHOD AND APPARATUS**

(57) A communication method and apparatus are provided. The method includes: A first device obtains configuration information of a reference signal, an interval range of each of a plurality of intervals, and a predistortion model parameter of each of the intervals, where the plurality of intervals are power intervals of the reference signal; the first device obtains a first reference signal based on the configuration information; the first device receives a reference signal from a second device, to obtain a second reference signal; and the first device determines, based on a predistortion model parameter of a first interval in the plurality of intervals, the first reference signal, and the second reference signal, a predistortion coefficient of the first interval. According to the method, algorithm complexity of predistortion training performed by the first device can be reduced, and accuracy of the predistortion coefficient obtained by the first device through calculation can also be improved.

FIG. 6

**Description**

This application claims priority to Chinese Patent Application No. 202211168582.5, filed with the China National Intellectual Property Administration on September 24, 2022 and entitled "COMMUNICATION METHOD AND APPARATUS", which is incorporated herein by reference in its entirety.

**TECHNICAL FIELD**

This application relates to the communication field, and more specifically, to a communication method and apparatus.

**BACKGROUND**

A power amplifier (power amplifier, PA) may amplify power of a low-power signal generated by a network device or a terminal device to a power level at which long-distance transmission can be performed. During power amplification (briefly referred to as power amplification), non-linear distortion is introduced for the PA. A predistortion technology is an effective means to improve linearity of an output signal of the PA. If predistortion processing is performed on a digital signal, it is referred to as digital predistortion (digital predistortion, DPD). If predistortion processing is performed on an analog signal, it is referred to as analog predistortion (analog predistortion, APD).

The network device or the terminal device may perform, based on a predistortion coefficient, predistortion processing on the signal before amplification performed by the PA. Currently, in a manner, in a process of performing predistortion training to obtain the predistortion coefficient, predistortion processing may be performed on an entire segment of a non-linear curve of the PA. However, based on this manner, a predistortion model order during predistortion training is large, resulting in high algorithm complexity, and accuracy of the predistortion coefficient obtained through calculation is low, resulting in deterioration of predistortion performance.

**SUMMARY**

This application provides a communication method and apparatus, to resolve the foregoing problems.

According to a first aspect, a communication method is provided, and includes: A first device obtains configuration information of a reference signal, an interval range of each of a plurality of intervals, and a predistortion model parameter of each of the plurality of intervals, where the plurality of intervals are power intervals of the reference signal; the first device obtains a first reference signal based on the configuration information; the first device receives a reference signal from a second device, to obtain a second reference signal; and the first device determines, based on a predistortion model parameter of a first interval in the plurality of intervals, the first reference signal, and the second reference signal, a predistortion coefficient of the first interval.

In comparison with a case in which the first device determines a predistortion coefficient of an entire segment of a non-linear curve of a PA, according to this embodiment of this application, the non-linear curve of the PA is divided into the plurality of intervals (a plurality of segments) based on a magnitude of input power, and the first device may determine the predistortion coefficient of the first interval at a granularity of an interval. Based on this, algorithm complexity of predistortion training performed by the first device can be reduced, and accuracy of the predistortion coefficient obtained by the first device through calculation can also be improved.

With reference to the first aspect, in some implementations of the first aspect, that the first device obtains a first reference signal based on the configuration information includes: The first device reconstructs the first reference signal based on the configuration information.

With reference to the first aspect, in some implementations of the first aspect, the method further includes: The first device sends the predistortion coefficient of the first interval to the second device.

With reference to the first aspect, in some implementations of the first aspect, the method further includes: The first device determines based on a predistortion model parameter of a second interval in the plurality of intervals, the first reference signal, and the second reference signal, a predistortion coefficient of the second interval.

With reference to the first aspect, in some implementations of the first aspect, that the first device determines, based on a predistortion model parameter of the first interval, the first reference signal, and the second reference signal, a predistortion coefficient of the first interval includes: The first device obtains first sampling point information based on the first reference signal, where the first sampling point information is sampling point information belonging to the first interval; the first device obtains second sampling point information based on the second reference signal, where the second sampling point information is sampling point information corresponding to the first sampling point information; and the first device determines the predistortion coefficient of the first interval based on the predistortion model parameter of the first interval in the plurality of intervals, the first sampling point information, and the second sampling point information.

With reference to the first aspect, in some implementations of the first aspect, the configuration information includes time-frequency resource information of the reference signal, sequence information of the reference signal, and one or more of the following: type information of the reference signal, antenna port information of the reference signal, bandwidth information of the reference signal, and a filter parameter, where the time-frequency resource information corresponds to the antenna port information.

With reference to the first aspect, in some implementations of the first aspect, the second reference signal is a signal obtained through amplification by at least one PA; and when the at least one PA is one PA, in the plurality of intervals, a largest value of interval endpoints corresponds to input power of a non-linear curve saturation point of the PA; or when the at least one PA is a plurality of PAs, in the plurality of intervals, a largest value of interval endpoints corresponds to input power of a non-linear curve saturation point of an equivalent PA of the plurality of PAs.

According to this embodiment of this application, because a non-linear curve of a PA after a saturation point is approximately horizontal, and a predistortion function curve is approximately vertical theoretically, to avoid damage to the device and prevent average power of a predistorted signal from being too high, a maximum value of endpoints of the plurality of intervals is set to input power of the non-linear curve saturation point of the PA, in other words, no predistortion training is performed on a reference signal sampling point whose input power is greater than the maximum value.

With reference to the first aspect, in some implementations of the first aspect, each of the plurality of intervals has a same length; or the plurality of intervals include the second interval, and a length of the first interval is different from a length of the second interval.

For example, the length of each of the plurality of intervals may be associated with linearity of the non-linear curve of the PA in the interval. For example, an interval length of a low-power interval is greater than an interval length of a high-power interval, to further improve accuracy of the predistortion coefficient obtained through calculation.

With reference to the first aspect, in some implementations of the first aspect, the predistortion model parameter of each of the plurality of intervals includes a non-linear order; and each of the plurality of intervals has a same non-linear order; or the plurality of intervals include a third interval, and a non-linear order of the first interval is different from a non-linear order of the third interval.

For example, the non-linear order of each of the plurality of intervals may be associated with the linearity of the non-linear curve of the PA in the interval. For example, a non-linear order of a low-power interval is less than a non-linear order of a high-power interval, to reduce algorithm complexity of performing predistortion training and improve efficiency of performing predistortion training.

With reference to the first aspect, in some implementations of the first aspect, when the second reference signal is a signal obtained through amplification by the plurality of PAs, the method further includes: The first device obtains second configuration information of the reference signal and a power amplification model parameter; the first device obtains a third reference signal based on the second configuration information; the first device receives reference signals from the second device, to obtain a fourth reference signal; the first device determines the non-linear curve saturation point of the equivalent PA of the plurality of PAs based on the power amplification model parameter, the third reference signal, and the fourth reference signal; and the first device sends first information to the second device, where the first information includes information about the non-linear curve saturation point of the equivalent PA.

According to this embodiment of this application, considering that the non-linear curve saturation point of the equivalent PA may be different from non-linear curve saturation points of the plurality of PAs, the first device may determine the non-linear curve saturation point of the equivalent PA. Based on this, subsequent division of a plurality of intervals can be more accurate, and performance of performing predistortion processing by the second device on the reference signal can be improved.

With reference to the first aspect, in some implementations of the first aspect, when the first device does not detect the non-linear curve saturation point of the equivalent PA, the first device sends second information to the second device, where the second information indicates to increase power of a reference signal before amplification performed by the plurality of PAs.

According to a second aspect, a communication method is provided, and includes: A second device performs power amplification on a first reference signal based on at least one PA; the second device sends, to a first device, a corresponding reference signal obtained through power amplification on the first reference signal; the second device receives a predistortion coefficient of a first interval from the first device; and the second device performs predistortion processing on a fifth reference signal based on the predistortion coefficient of the first interval, where power of the fifth reference signal is in the first interval, and the fifth reference signal is a signal before power amplification.

In comparison with a case in which the second device performs predistortion processing on the fifth reference signal by using a predistortion coefficient of an entire segment of a non-linear curve of a PA, according to this embodiment of this application, the second device may perform predistortion processing on the fifth reference signal based on the predistortion coefficient of the first interval. Because the predistortion coefficient of the first interval is more accurate than the predistortion coefficient of the entire segment, performance of performing predistortion processing by the second device on the reference signal can be improved by using the method in this application.

With reference to the second aspect, in some implementations of the second aspect, the method further includes: The second device sends configuration information of a reference signal, an interval range of each of a plurality of intervals, and a predistortion model parameter of each of the plurality of intervals to the first device, where the configuration information includes time-frequency resource information of the reference signal and sequence information of the reference signal, and the plurality of intervals include the first interval.

Optionally, to indicate the interval range of each of the plurality of intervals, the second device may send interval endpoint information of each of the intervals to the first device. Alternatively, the second device may send information about a 1st endpoint and an interval length of each of the intervals to the first device. Alternatively, the second device may send a quantity of the intervals to the first device, and the first device subsequently determines the interval range of each of the intervals.

With reference to the second aspect, in some implementations of the second aspect, the configuration information further includes one or more of the following: type information of the reference signal, antenna port information of the reference signal, bandwidth information of the reference signal, and a filter parameter, where the time-frequency resource information corresponds to the antenna port information.

According to this embodiment of this application, the second device sends the bandwidth information of the reference signal and/or the filter parameter to the first device, so that accuracy of the pre-PA signal obtained by the first device through calculation can be improved, and accuracy of the predistortion coefficient obtained by the first device through calculation can be further improved.

With reference to the second aspect, in some implementations of the second aspect, each of the plurality of intervals has a same length; or the plurality of intervals include a second interval, and a length of the first interval is different from a length of the second interval.

With reference to the second aspect, in some implementations of the second aspect, the at least one PA is one PA, and in the plurality of intervals, a largest value of interval endpoints corresponds to input power of a non-linear curve saturation point of the PA; or the at least one PA is a plurality of PAs, and in the plurality of intervals, a largest value of interval endpoints corresponds to input power of a non-linear curve saturation point of an equivalent PA of the plurality of PAs.

With reference to the second aspect, in some implementations of the second aspect, the predistortion model parameter of each of the plurality of intervals includes a non-linear order; and each of the plurality of intervals has a same non-linear order; or the plurality of intervals include a third interval, and a non-linear order of the first interval is different from a non-linear order of the third interval.

With reference to the second aspect, in some implementations of the second aspect, when the at least one PA is the plurality of PAs, the method further includes: The second device sends second configuration information of the reference signal and a PA model parameter to the first device; the second device performs power amplification on a third reference signal based on the plurality of PAs; the second device sends, to the first device, a corresponding reference signal obtained through power amplification on the third reference signal; and the second device receives first information from the first device, where the first information includes information about the non-linear curve saturation point of the equivalent PA of the plurality of PAs.

With reference to the second aspect, in some implementations of the second aspect, the method further includes: The second device skips performing crest factor reduction (crest factor reduction, CFR) processing on the third reference signal.

According to this embodiment of this application, the second device skips performing CFR processing on the third reference signal, so that a probability that power of the reference signal reaches the non-linear curve saturation point of the equivalent PA can be increased.

With reference to the second aspect, in some implementations of the second aspect, the method further includes: The second device receives second information from the first device, where the second information indicates to increase power of a reference signal before amplification performed by the plurality of PAs; and the second device increases, based on the second information, the power of the reference signal before amplification performed by the plurality of PAs.

According to a third aspect, a communication apparatus is provided. The communication apparatus may be a first device, or may be an apparatus (for example, a chip, a chip system, or a circuit) in the first device, or an apparatus that can be used together with the first device.

In a possible implementation, the communication apparatus may include a module or a unit in one-to-one correspondence with the method/operation/step/action described in the first aspect. The module or the unit may be a hardware circuit, or may be software, or may be implemented by a hardware circuit in combination with software.

In a possible implementation, the communication apparatus includes a transceiver unit and a processing unit connected to the transceiver unit.

The transceiver unit is configured to obtain configuration information of a reference signal, an interval range of each of a plurality of intervals, and a predistortion model parameter of each of the plurality of intervals, where the plurality of intervals are power intervals of the reference signal; the processing unit is configured to obtain a first reference signal based on the configuration information; the transceiver unit is configured to receive a reference signal from a second device, to obtain a second reference signal; and the processing unit is configured to determine, based on a predistortion model parameter of a first interval, the first reference signal, and the second reference signal, a predistortion coefficient of the first interval.

With reference to the third aspect, in some implementations of the third aspect, the processing unit is configured to reconstruct the first reference signal based on the configuration information.

With reference to the third aspect, in some implementations of the third aspect, the transceiver unit is configured to send the predistortion coefficient of the first interval to the second device.

With reference to the third aspect, in some implementations of the third aspect, the processing unit is configured to determine, based on a predistortion model parameter of a second interval in the plurality of intervals, the first reference signal, and the second reference signal, a predistortion coefficient of the second interval.

With reference to the third aspect, in some implementations of the third aspect, the processing unit is configured to obtain first sampling point information based on the first reference signal, where the first sampling point information is sampling point information belonging to the first interval; the processing unit is configured to obtain second sampling point information based on the second reference signal, where the second sampling point information is sampling point information corresponding to the first sampling point information; and the processing unit is configured to determine the predistortion coefficient of the first interval based on the predistortion model parameter of the first interval in the plurality of intervals, the first sampling point information, and the second sampling point information.

With reference to the third aspect, in some implementations of the third aspect, the configuration information includes time-frequency resource information of the reference signal, sequence information of the reference signal, and one or more of the following: type information of the reference signal, antenna port information of the reference signal, bandwidth information of the reference signal, and a filter parameter, where the time-frequency resource information corresponds to the antenna port information.

With reference to the third aspect, in some implementations of the third aspect, the second reference signal is a signal obtained through amplification by at least one PA; and when the at least one PA is one PA, in the plurality of intervals, a largest value of interval endpoints corresponds to input power of a non-linear curve saturation point of the PA; or when the at least one PA is a plurality of PAs, in the plurality of intervals, a largest value of interval endpoints corresponds to input power of a non-linear curve saturation point of an equivalent PA of the plurality of PAs.

With reference to the third aspect, in some implementations of the third aspect, each of the plurality of intervals has a same length; or the plurality of intervals include the second interval, and a length of the first interval is different from a length of the second interval.

With reference to the third aspect, in some implementations of the third aspect, the predistortion model parameter of each of the plurality of intervals includes a non-linear order; and each of the plurality of intervals has a same non-linear order; or the plurality of intervals include a third interval, and a non-linear order of the first interval is different from a non-linear order of the third interval.

With reference to the third aspect, in some implementations of the third aspect, when the second reference signal is a signal obtained through amplification by the plurality of PAs, the transceiver unit is configured to obtain second configuration information of the reference signal and a power amplification model parameter; the processing unit is configured to obtain a third reference signal based on the second configuration information; the transceiver unit is configured to receive reference signals from the second device, to obtain a fourth reference signal; the processing unit is configured to determine the non-linear curve saturation point of the equivalent PA of the plurality of PAs based on the power amplification model parameter, the third reference signal, and the fourth reference signal; and the transceiver unit is configured to send first information to the second device, where the first information includes information about the non-linear curve saturation point of the equivalent PA.

With reference to the third aspect, in some implementations of the third aspect, when the first device does not detect the non-linear curve saturation point of the equivalent PA, the transceiver unit is configured to send second information to the second device, where the second information indicates to increase power of a reference signal before amplification performed by the plurality of PAs.

According to a fourth aspect, a communication apparatus is provided. The communication apparatus may be a second device, or may be an apparatus (for example, a chip, a chip system, or a circuit) in the second device, or an apparatus that can be used together with the second device.

In a possible implementation, the communication apparatus may include a module or a unit in one-to-one correspondence with the method/operation/step/action described in the second aspect. The module or the unit may be a hardware circuit, or may be software, or may be implemented by a hardware circuit in combination with software.

In a possible implementation, the communication apparatus includes a transceiver unit and a processing unit connected to the transceiver unit.

The processing unit is configured to perform power amplification on a first reference signal based on at least one PA; the transceiver unit is configured to send, to a first device, a corresponding reference signal obtained through power amplification on the first reference signal; the transceiver unit is configured to receive a predistortion coefficient of a first interval from the first device; and the processing unit is configured to perform predistortion processing on a fifth reference signal based on the predistortion coefficient of the first interval, where power of the fifth reference signal is in the first interval, and the fifth reference signal is a signal before power amplification.

With reference to the fourth aspect, in some implementations of the fourth aspect, the transceiver unit is configured to send configuration information of the reference signal, an interval range of each of a plurality of intervals, and a predistortion model parameter of each of the plurality of intervals to the first device, where the configuration information includes time-frequency resource information of the reference signal and sequence information of the reference signal, and the plurality of intervals include the first interval.

With reference to the fourth aspect, in some implementations of the fourth aspect, the configuration information further includes one or more of the following: type information of the reference signal, antenna port information of the reference signal, bandwidth information of the reference signal, and a filter parameter, where the time-frequency resource information corresponds to the antenna port information.

With reference to the fourth aspect, in some implementations of the fourth aspect, each of the plurality of intervals has a same length; or the plurality of intervals include a second interval, and a length of the first interval is different from a length of the second interval.

With reference to the fourth aspect, in some implementations of the fourth aspect, the at least one PA is one PA, and in the plurality of intervals, a largest value of interval endpoints corresponds to input power of a non-linear curve saturation point of the PA; or the at least one PA is a plurality of PAs, and in the plurality of intervals, a largest value of interval endpoints corresponds to input power of a non-linear curve saturation point of an equivalent PA of the plurality of PAs.

With reference to the fourth aspect, in some implementations of the fourth aspect, the predistortion model parameter of each of the plurality of intervals includes a non-linear order; and each of the plurality of intervals has a same non-linear order; or the plurality of intervals include a third interval, and a non-linear order of the first interval is different from a non-linear order of the third interval.

With reference to the fourth aspect, in some implementations of the fourth aspect, when the at least one PA is the plurality of PAs, the transceiver unit is configured to send second configuration information of the reference signal and a PA model parameter to the first device; the processing unit is configured to perform power amplification on a third reference signal based on the plurality of PAs; the transceiver unit is configured to send, to the first device, a corresponding reference signal obtained through power amplification on the third reference signal; and the transceiver unit is configured to receive first information from the first device, where the first information includes information about the non-linear curve saturation point of the equivalent PA of the plurality of PAs.

With reference to the fourth aspect, in some implementations of the fourth aspect, the processing unit is configured to skip performing crest factor reduction CFR processing on the third reference signal.

With reference to the fourth aspect, in some implementations of the fourth aspect, the transceiver unit is configured to receive second information from the first device, where the second information indicates to increase power of a reference signal before amplification performed by the plurality of PAs; and the processing unit is configured to increase, based on the second information, the power of the reference signal before amplification performed by the plurality of PAs.

According to a fifth aspect, a communication apparatus is provided, and includes a communication interface and a processor, where the communication interface is configured to output and/or input a signal, and the processor is configured to execute a computer program or instructions stored in a memory, to cause the communication apparatus to perform the method according to any one of possible implementations of the first aspect, or to cause the communication apparatus to perform the method according to any one of possible implementations of the second aspect.

Optionally, the memory may be included in the communication apparatus. In a manner, the memory may be arranged separately from the processor. In another manner, the memory may be located in the processor and integrated with the processor.

Optionally, the memory may alternatively be outside the communication apparatus and coupled to the processor.

According to a sixth aspect, a computer-readable storage medium is provided, and includes a computer program. When the computer program is run on a computer, the computer is caused to perform the method according to any one of possible implementations of the first aspect, or the computer is caused to perform the method according to any one of possible implementations of the second aspect.

According to a seventh aspect, a chip or a chip system is provided. The chip or the chip system includes a processing circuit and an input/output interface. The processing circuit is configured to perform the method according to any one of possible implementations of the first aspect; or the processing circuit is configured to perform the method according to any one of possible implementations of the second aspect. The input/output interface is configured to input and/or output a signal.

According to an eighth aspect, a computer program product is provided. The computer program product includes a computer program (which may also be referred to as code or instructions). When the computer program is run, a computer is caused to perform the method according to any one of possible implementations of the first aspect, or a computer is caused to perform the method according to any one of possible implementations of the second aspect.

According to a ninth aspect, a communication system is provided, and includes a first device and a second device. The first device is configured to perform the method according to any one of possible implementations of the first aspect. The second device is configured to perform the method according to any one of possible implementations of the second aspect.

## BRIEF DESCRIPTION OF DRAWINGS

FIG. 1 shows a communication system to which this application is applicable;
FIG. 2 shows a basic principle of a digital predistortion technology;
FIG. 3 shows a manner in which a transmitter obtains a DPD coefficient;
FIG. 4 shows an ABF or HBF architecture;
FIG. 5 shows a manner of performing predistortion training;
FIG. 6 is an interaction diagram of an example of a method according to this application;
FIG. 7 shows a position occupied by a reference signal in time domain;
FIG. 8 shows a quantity of symbols occupied by a reference signal in one slot;
FIG. 9(a) and FIG. 9(b) show two manners of segmenting a non-linear curve of a PA;
FIG. 10 shows a relationship between a non-linear curve of a PA and a predistortion function curve;
FIG. 11 shows a plurality of sampling points of a reconstructed pre-PA signal;
FIG. 12 is an example diagram of a method according to this application;
FIG. 13 shows a case in which a non-linear curve saturation point of an equivalent PA shifts;
FIG. 14 is an interaction diagram of an example of a method according to this application;
FIG. 15 shows a position of a CFR module;
FIG. 16 shows that devices for saturation point detection and predistortion training may be the same or may be different;
FIG. 17 is a block diagram of a communication apparatus according to this application; and
FIG. 18 is a block diagram of a communication device according to this application.

## DESCRIPTION OF EMBODIMENTS

Technical solutions in embodiments of this application may be applied to various 3rd generation partnership project (the 3rd generation partnership project, 3GPP) communication systems, such as a long term evolution (long term evolution, LTE) system, an LTE frequency division duplex (frequency division duplex, FDD) system, an LTE time division duplex (time division duplex, TDD) system, a 5th generation (5th Generation, 5G) communication system, also referred to as a new radio (new radio, NR) communication system, and a future evolved communication system, for example, a 6th generation (6th Generation, 6G) communication system.

It should be understood that, the term "and/or" in this specification merely describes an association relationship between associated objects, and indicates that three relationships may exist. For example, A and/or B may indicate the following three cases: Only A exists, both A and B exist, and only B exists. In addition, the character "/" in this application may indicate "and/or". For example, A/B indicates A and/or B.

It should be understood that, in embodiments of this application, "B corresponding to A" indicates that B is associated with A, and B may be determined based on A. However, it should be further understood that, determining B based on A does not mean that B is determined only based on A. B may alternatively be determined based on A and/or other information.

"A plurality of" in embodiments of this application refers to two or more.

Descriptions such as "first" and "second" in embodiments of this application are merely used as an example and for distinguishing between described objects, and there is no difference in sequence. In addition, the descriptions do not indicate a special limitation on a quantity of described objects in embodiments of this application, and shall not constitute any limitation on embodiments of this application.

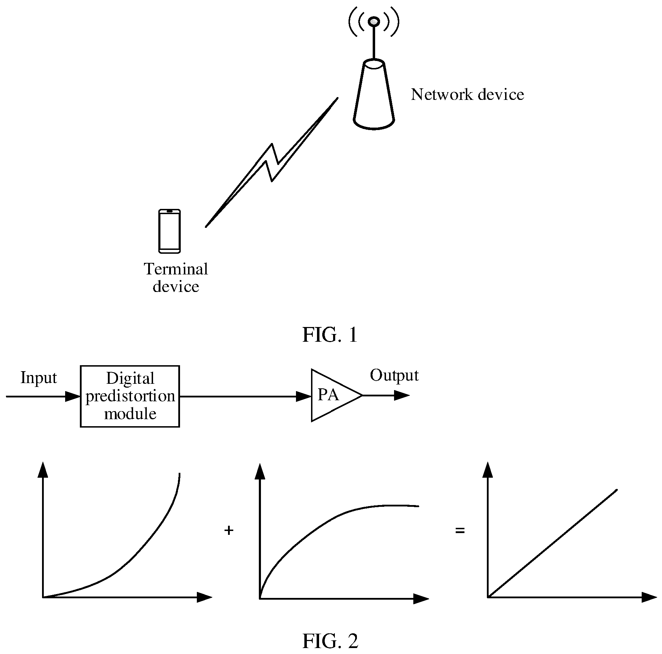

FIG. 1 shows a system architecture to which this application is applicable. The system architecture includes a terminal device and a network device.

For ease of understanding, some terms in embodiments of this application are first explained and described.

(1) Network device

The network device in embodiments of this application may be an access network device, for example, a base station. The base station may be an evolved NodeB (evolved NodeB, eNB or eNodeB) in an LTE system, a next generation NodeB (next generation NodeB, gNB) in a 5th generation (5th generation, 5G) mobile communication system, a next generation base station in a communication system evolved after 5G, for example, a 6th generation (6th generation, 6G) mobile communication system. A specific technology and a specific device form used by the network device are not limited in embodiments of this application. For example, the network device may be a macro base station, a micro base station (also referred to as a small cell), a relay station, an access point, a transmission reception point (transmission reception point, TRP), a transmission point (transmission point, TP), a mobile switching center, a network device in a non-terrestrial network (non-terrestrial network, NTN) communication system (that is, the network device may be deployed on a high-altitude platform or a satellite), or a device that functions as a base station in device-to-device (device-to-device, D2D) communication, vehicle to everything (vehicle to everything, V2X) communication, and machine-type communication (machine-type communication, MTC) communication.

The network device may be a module or a unit that completes a part of functions of the base station, for example, may be a central unit (central unit, CU), or may be a distributed unit (distributed unit, DU). The CU and the DU separately complete a part of protocol stack functions of the base station. In addition, functions of the CU may be implemented by a plurality of entities. For example, functions of a control plane (control plane, CP) and a user plane (user plane, UP) of the CU are separated, to form a CU control plane (CU-CP) and a CU user plane (CU-UP). For example, the CU-CP and the CU-UP may be implemented by different functional entities, and are connected through an E1 interface. The CU-CP and the CU-UP may be coupled to the DU.

For example, the network device may further include an active antenna unit (active antenna unit, AAU). The CU is responsible for processing a non-real-time protocol and service, and implements functions of a radio resource control (radio resource control, RRC) layer and a packet data convergence protocol (packet data convergence protocol, PDCP) layer. The DU is responsible for processing a physical layer protocol and a real-time service, and implementing functions of a radio link control (radio link control, RLC) layer, a media access control (media access control, MAC) layer, and a physical (physical, PHY) layer. The AAU implements a part of physical layer processing functions, radio frequency processing, and functions related to an active antenna. Information at the RRC layer is finally changed to information at the PHY layer, or is changed from information at the PHY layer. Therefore, in this architecture, higher layer signaling (for example, RRC layer signaling) may also be considered to be sent by the DU, or sent by the DU and the AAU. It may be understood that, the network device may be a device including one or more of a CU node, a DU node, and an AAU node. In addition, the CU may be divided into a network device in an access network (a radio access network, RAN), or the CU may be divided into a network device in a core network (core network, CN). This is not limited in this application.

(2) Terminal device

In this application, the terminal device may be various devices that provide voice and/or data connectivity for a user, and may also be referred to as a terminal, user equipment (user equipment, UE), a mobile station, a mobile terminal, or the like. The terminal device may be widely used in various scenarios, such as customer-premises equipment (customer-premises equipment, CPE), a smart point of sale (point of sale, POS) machine, D2D communication, V2X communication, MTC, an internet of things (internet of things, IoT), virtual reality, augmented reality, industrial control, autonomous driving, telemedicine, a smart grid, smart furniture, a smart office, smart wearable, smart transportation, and a smart city. The terminal may be a mobile phone, a tablet computer, a computer with a wireless transceiver function, a wearable device, an unmanned aerial vehicle, a vehicle-mounted device, an aerospace device, or the like. In embodiments of this application, a chip used in the foregoing device may also be referred to as the terminal.

(3) Beam

The beam in an NR protocol may be a spatial domain filter (spatial domain filter), or referred to as a spatial filter (spatial filter), a spatial domain parameter (spatial domain parameter), a spatial parameter (spatial parameter), a spatial domain setting (spatial domain setting), a spatial setting (spatial setting), quasi co-location (quasi-colocation, QCL) information, QCL assumption, QCL indication, or the like. The beam may be indicated via a transmission configuration indicator state (transmission configuration indicator state, TCI-state) parameter or indicated via a spatial relation (spatial relation) parameter. Therefore, in this application, the beam may be replaced with a spatial domain filter, a spatial filter, a spatial domain parameter, a spatial parameter, a spatial domain setting, a spatial setting, QCL information, QCL assumption, QCL indication, a TCI-state (including an uplink TCI-state or a downlink TCI-state), a spatial relation, or the like. The foregoing terms are also equivalent to each other. Alternatively, the beam may be replaced with another term for representing a beam. This is not limited in this application.

A beam used for sending a signal may be referred to as a transmit beam (transmit beam, Tx beam), or may be referred to as a spatial domain transmission filter (spatial domain transmission filter), a spatial transmission filter (spatial transmission filter), a spatial domain transmission parameter (spatial domain transmission parameter), a spatial transmission parameter (spatial transmission parameter), a spatial domain transmission setting (spatial domain transmission setting), or a spatial transmission setting (spatial transmission setting). A downlink transmit beam may be indicated via a TCI-state.

A beam used for receiving a signal may be referred to as a receive beam (receive beam, Rx beam), or may be referred to as a spatial domain reception filter (spatial domain reception filter), a spatial reception filter (spatial reception filter), a spatial domain reception parameter (spatial domain reception parameter), a spatial reception parameter (spatial reception parameter), a spatial domain reception setting (spatial domain reception setting), or a spatial reception setting (spatial reception setting). An uplink transmit beam may be indicated via a spatial relation, an uplink TCI-state, or a channel sounding reference signal (sounding reference signal, SRS) resource (indicating a transmit beam that uses an SRS). Therefore, the uplink beam may alternatively be replaced with an SRS resource.

The transmit beam may be signal strength distribution formed in different directions in space after a signal is transmitted through an antenna, and the receive beam may be signal strength distribution, in different directions in space, of a radio signal received from an antenna.

In addition, the beam may be a wide beam, a narrow beam, or another type of beam. A technology for forming the beam may be a beamforming technology or another technology. The beamforming technology may be specifically a digital beamforming technology, an analog beamforming technology, a hybrid digital beamforming technology, a hybrid analog beamforming technology, or the like.

The beam corresponds to configuration information of a reference signal. For example, when performing beam measurement, a network device may determine quality of different beams based on quality of different reference signals. A terminal device measures the reference signal, and feeds back quality of the reference signal to the network device. The network device may determine quality of the beam based on the quality of the reference signal. For the configuration information of the reference signal, refer to the following related descriptions. During data transmission, beam information is also indicated via configuration information of a reference signal corresponding to the beam information. For example, the network device indicates information about a physical downlink shared channel (physical downlink shared channel, PDSCH) beam of the terminal device via a TCI field in downlink control information (downlink control information, DCI). In a possible implementation, a plurality of beams having a same or similar communication characteristic are considered as one beam.

(4) Configuration information of a reference signal

In this application, the reference signal may be an uplink reference signal, or may be a downlink reference signal. The uplink reference signal includes but is not limited to a sounding reference signal (sounding reference signal, SRS) and a demodulation reference signal (demodulation reference signal, DMRS). The downlink reference signal includes but is not limited to a channel state information-reference signal (channel state information-reference signal, CSI-RS), a cell-specific reference signal (cell-specific reference signal, CS-RS), a UE-specific reference signal (user equipment specific reference signal, US-RS), a DMRS, or a synchronization signal/physical broadcast channel block (synchronization system/physical broadcast channel block, SS/PBCH block). The SS/PBCH block may be briefly referred to as a synchronization signal block (synchronization signal block, SSB).

The configuration information of the reference signal may be configured via RRC signaling. In terms of a configuration structure, the configuration information of the reference signal corresponds to a data structure, and includes a related parameter of an uplink reference signal corresponding to the configuration information or a related parameter of a downlink reference signal corresponding to the configuration information.

For example, for the uplink reference signal, the configuration information of the reference signal includes at least one of the following: a type of the uplink reference signal, a resource element (which may also be referred to as a time-frequency resource) that carries the uplink reference signal, sending time and a sending periodicity of the uplink reference signal, sequence information of the uplink reference signal, an antenna port used for sending the uplink reference signal, and the like.

For another example, for the downlink reference signal, the configuration information of the reference signal includes at least one of the following: a type of the downlink reference signal, a resource element (which may also be referred to as a time-frequency resource) that carries the downlink reference signal, sending time and a sending periodicity of the downlink reference signal, sequence information of the downlink reference signal, an antenna port used for sending the downlink reference signal, and the like.

The sequence information of the reference signal may include a sequence type corresponding to the reference signal. For example, the sequence may be a Zadoff-Chu (ZC) sequence, a Gold sequence, or the like.

(5) Resource

In this application, the "resource" may be understood as a time-frequency resource that is configured in configuration information of a reference signal and that is used for carrying the reference signal.

(6) DPD technology

As shown in FIG. 2, a basic principle of the digital predistortion technology is to perform digital preprocessing on a signal before power amplification, to improve linearity of a signal output by a PA. Theoretically, a DPD function is an inverse function of a PA response function.

(7) Sampling point and sampling point information

The sampling point in this application may be a sampling point of a reference signal in time domain.

The sampling point information in this application includes position information of the sampling point and instantaneous power information of the sampling point. For example, the position information of the sampling point may be sequence position information of the sampling point.

(8) Non-linear curve saturation point of a PA

The non-linear curve saturation point of the PA is an inherent attribute of the PA. After the saturation point, output power of the PA hardly changes as input power increases.

The non-linear curve of the PA and the non-linear curve saturation point of the PA may be affected by external environment. The external environment may include a temperature, humidity, and the like. For example, the non-linear saturation point of the PA may vary with a temperature.

The following describes a first technical problem of this application.

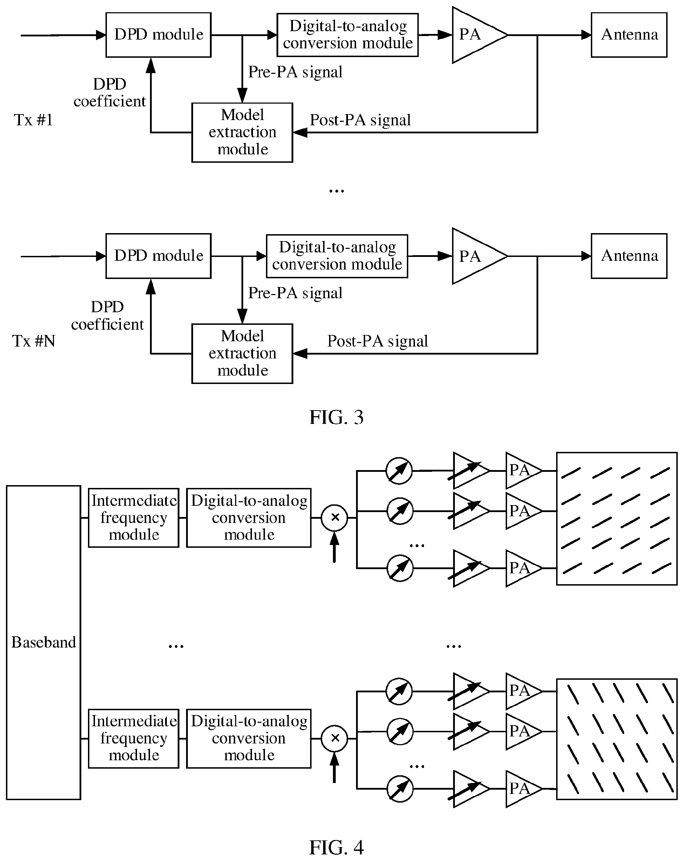

As shown in FIG. 3, in a possible manner, before performing DPD processing on a reference signal, a transmitter may obtain a DPD coefficient via a pre-PA signal and a post-PA signal. The pre-PA signal may be directly obtained from a digital module. In some scenarios (for example, in a low-frequency scenario), the transmitter may collect the post-PA signal through a feedback channel. When the transmitter has a plurality of PAs, each of the PAs may have an independent feedback channel, and the transmitter may perform DPD compensation on each of the PAs.

In this application, the pre-PA signal may be understood as a signal before amplification performed by a PA, and the post-PA signal may be understood as a signal obtained through amplification by a PA.

With development of technologies, in a millimeter wave frequency band, the transmitter uses more antennas to obtain array gains, to counter a greater propagation loss of a highfrequency signal. For example, a quantity of elements included in a base station device in a frequency band of 26 GHz to 28 GHz may reach hundreds or thousands. To avoid excessively high costs and power consumption caused by a large-scale array, the base station device may use an analog beamforming (analog beamforming, ABF) architecture or a hybrid beamforming (Hybrid beamforming, HBF) architecture.

FIG. 4 shows a form of an ABF or HBF architecture. In the ABF or HBF architecture, one digital channel may correspond to a plurality of PAs, and the plurality of PAs may be considered as being connected in parallel. In the ABF or HBF architecture, if a transmitter performs DPD compensation on the plurality of PAs of the digital channel one by one, implementation is complex and difficult.

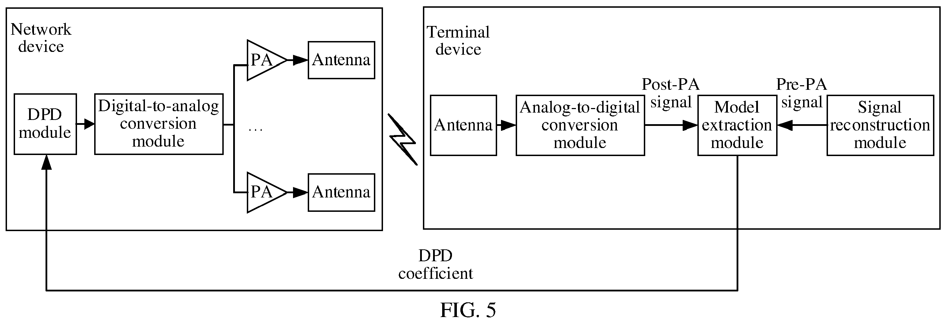

FIG. 5 shows a manner of performing predistortion training in an ABF or HBF architecture. This manner may also be referred to as over the air (over the air, OTA) DPD.

In FIG. 5, one digital channel of a network device may correspond to one or more PAs (in FIG. 5, an example in which one digital channel corresponds to a plurality of PAs is used). A model extraction module in a terminal device is configured to: perform predistortion training based on a pre-PA signal and a post-PA signal, to obtain a DPD coefficient, and feed back the DPD coefficient to the network device.

In FIG. 5, if one digital channel of the network device corresponds to a plurality of PAs, the post-PA signal received by the terminal device may be considered as a reference signal obtained by combining a plurality of reference signals. Therefore, the post-PA signal includes combination of non-linear effects of the plurality of PAs. The DPD coefficient obtained by the terminal device may be used for compensating for the non-linear effects of the plurality of PAs, so that nonlinearity of the post-PA signal (the combined signal of the plurality of reference signals) is corrected. In other words, if one digital channel corresponds to a plurality of PAs, the plurality of PAs may be equivalent to one PA.

However, in a process of performing predistortion training to obtain a predistortion coefficient, the terminal device performs predistortion processing on an entire segment of a non-linear curve of the equivalent PA. Based on this manner, a predistortion model order during predistortion training is large, resulting in high algorithm complexity; and accuracy of the predistortion coefficient obtained through calculation is low, resulting in deterioration of predistortion performance.

To resolve the foregoing problem, this application provides a method 200. In the method 200, a non-linear curve of a PA is divided into a plurality of intervals (a plurality of segments). A first device determines a predistortion coefficient of an interval at a granularity of an interval, and feeds back the predistortion coefficient of the interval to a second device. In this embodiment of this application, the first device may be a terminal device, and the second device may be a network device. Alternatively, the first device may be a network device, and the second device may be a terminal device.

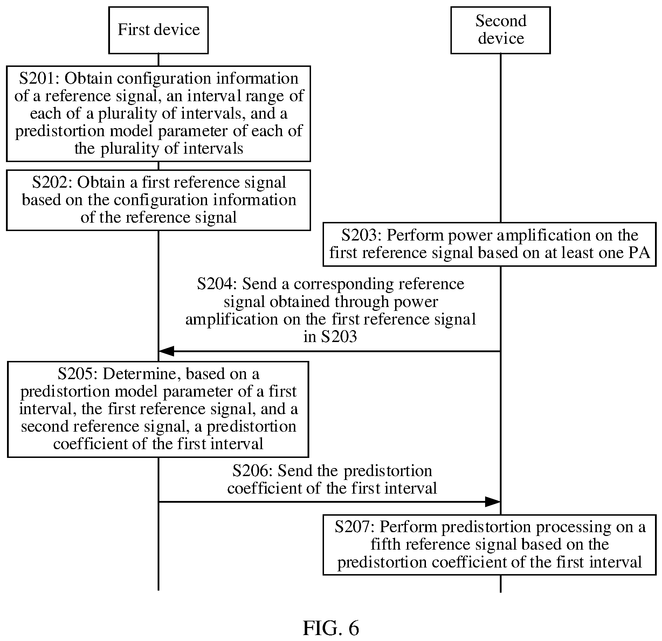

Specifically, as shown in FIG. 6, the method 200 includes the following steps.

S201: The first device obtains configuration information of a reference signal, an interval range of each of a plurality of intervals, and a predistortion model parameter of each of the plurality of intervals.

The plurality of intervals are power intervals before the reference signal is amplified by at least one PA, and a union set of the plurality of intervals is a first range. In other words, in this application, the first range is further divided into the plurality of intervals.

In a case, the at least one PA is one PA. The first range corresponds to an entire segment of a non-linear curve of the PA.

In another case, the at least one PA is a plurality of PAs. In this case, the plurality of PAs correspond to a same digital channel, and the plurality of PAs may be equivalent to one PA. The first range corresponds to an entire segment of a non-linear curve of the equivalent PA of the plurality of PAs.

The following describes the information obtained by the first device in S201.

(1) Configuration information of the reference signal

The configuration information of the reference signal includes time-frequency resource information of the reference signal and sequence information of the reference signal. Optionally, the configuration information further includes one or more of the following:
type information of the reference signal, antenna port information of the reference signal, bandwidth information of the reference signal, and a filter parameter.

The time-frequency resource information of the reference signal corresponds to the antenna port information of the reference signal. The sequence information of the reference signal may include a sequence type corresponding to the reference signal. The time-frequency resource information of the reference signal may include a slot offset of the reference signal in one slot, a quantity of symbols occupied by the reference signal in one slot, a sending periodicity of the reference signal, and a frequency domain position occupied by the reference signal.

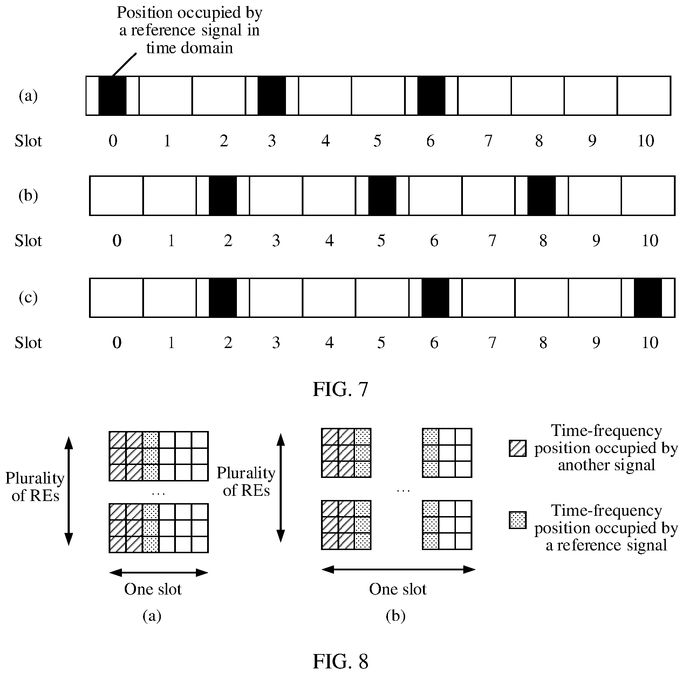

For example, as shown in (a) in FIG. 7, the sending periodicity of the reference signal is three slots, and the slot offset of the reference signal is zero slots. As shown in (b) in FIG. 7, the sending periodicity of the reference signal is three slots, and the slot offset of the reference signal is two slots. As shown in (c) in FIG. 7, the sending periodicity of the reference signal is four slots, and the slot offset of the reference signal is two slots.

For example, as shown in (a) in FIG. 8, the reference signal may occupy one orthogonal frequency division multiplexing (orthogonal frequency division multiplexing, OFDM) symbol or one discrete Fourier transform spread orthogonal frequency division multiplexing (discrete Fourier transform spread orthogonal frequency division multiplexing, DFT-S-OFDM) symbol in one slot. As shown in (b) in FIG. 8, the reference signal may occupy a plurality of OFDM symbols or DFT-S-OFDM symbols in one slot. Because a memory effect of the PA is closely related to bandwidth of an input signal, the reference signal may occupy all channel bandwidth of a subsequent data transmission signal in frequency domain.

After the reference signal is amplified by the at least one PA, a spectrum is broadened (for example, the spectrum is expanded by three to five times). The first device (for example, a terminal device) can usually obtain only a post-PA signal of a part of bandwidth. To improve accuracy of a result of the predistortion coefficient obtained through training, the first device obtains the bandwidth information of the reference signal (original bandwidth of the reference signal), and then performs predistortion training by using a band-limited algorithm model.

(2) Interval range of each of the plurality of intervals

In this application, if the at least one PA is one PA, a non-linear curve of the PA is divided into a plurality of intervals based on magnitudes of input power. If the at least one PA is a plurality of PAs, a non-linear curve of an equivalent PA of the plurality of PAs are divided into a plurality of intervals based on magnitudes of input power.

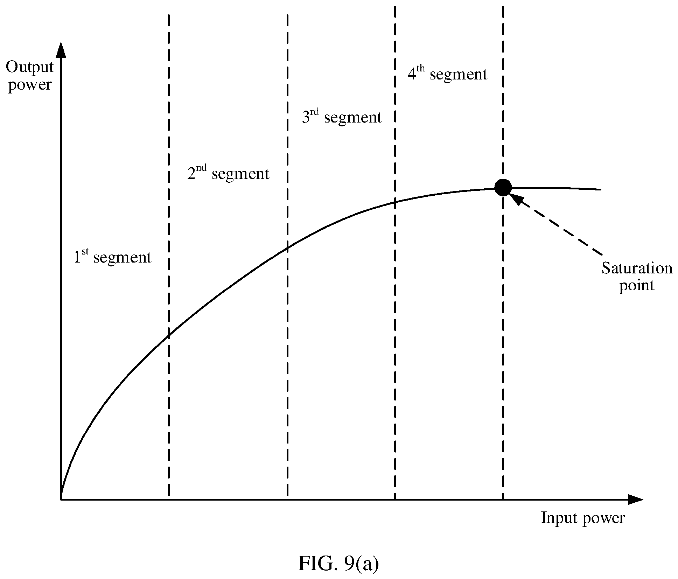

In a manner, each of the plurality of intervals has a same length. As shown in FIG. 9(a), the non-linear curve is divided into four intervals (four segments) before a saturation point, and a length of each of the intervals is the same.

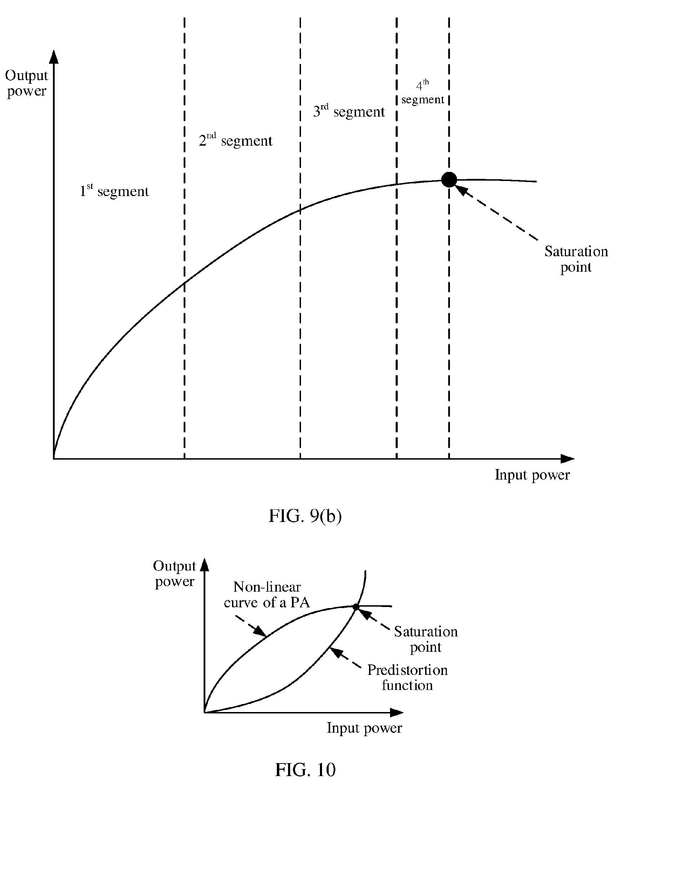

In another manner, at least two of the plurality of intervals may have different lengths. As shown in FIG. 9(b), the non-linear curve is divided into four intervals (four segments) before a saturation point, and a length of each of the intervals is different. The length of each of the plurality of intervals is associated with linearity of the non-linear curve in the interval. In a case, a smaller value of the linearity indicates a better linear characteristic of the curve.

For example, the plurality of intervals include a second interval. If a value of linearity of a first interval is less than a value of linearity of the second interval, a length of the first interval is greater than a length of the second interval. Conversely, if a value of linearity of a first interval is greater than a value of linearity of the second interval, a length of the first interval is less than a length of the second interval.

According to this embodiment of this application, through the foregoing non-uniform segmentation, a quantity of reference signal sampling points distributed in each of the intervals may be large and quantities may be approximately equal, to ensure robustness of predistortion training, improve predistortion training effects, and improve accuracy of the predistortion coefficient obtained through calculation.

Optionally, input power corresponding to the non-linear curve saturation point is in the plurality of intervals. For example, the at least one PA is one PA, and in the plurality of intervals, a largest value of interval endpoints corresponds to input power of a non-linear curve saturation point of the PA; or the at least one PA is a plurality of PAs, and in the plurality of intervals, a largest value of interval endpoints corresponds to input power of a non-linear curve saturation point of an equivalent PA of the plurality of PAs.

According to this embodiment of this application, as shown in FIG. 10, a non-linear curve of a PA after a saturation point is approximately horizontal, and a predistortion function curve is approximately vertical theoretically. Therefore, to avoid damage to the second device (for example, a network device) and prevent average power of a predistorted signal from being too high, a maximum value of endpoints of the plurality of intervals is set to the input power of the non-linear curve saturation point of the PA, in other words, no predistortion training is performed on a reference signal sampling point whose input power is greater than the maximum value.

(3) Predistortion model parameter of each of the plurality of intervals

The predistortion model parameter includes a predistortion model type and a predistortion model order.

The predistortion model type may be a polynomial model, a memory polynomial (memory polynomial, MP) model, or a generalized memory polynomial (generalized memory polynomial, GMP) model. In an implementation, a predistortion model type corresponding to each of the plurality of intervals is the same.

The predistortion model order includes a non-linear order, a memory depth, and a cross term length, which may be respectively represented by K, M, and G. For the polynomial model, M=G=0. For the memory polynomial model, G=0. For the generalized memory polynomial model, each of K, M, and G is non-zero.

For the non-linear order in the model order, optionally, in a case, a non-linear order of each of the plurality of intervals is the same. Optionally, in another case, a non-linear order of each of the plurality of intervals may be associated with linearity of the non-linear curve in the interval.

For example, the plurality of intervals include a third interval. If a value of linearity of a first interval is less than a value of linearity of the third interval, a non-linear order of the first interval is less than a non-linear order of the third interval. Conversely, if a value of linearity of a first interval is greater than a value of linearity of the third interval, a non-linear order of the first interval is greater than a non-linear order of the third interval.

According to this embodiment of this application, the linearity of the interval is associated with the non-linear order of the interval, so that algorithm complexity of predistortion training can be reduced, and efficiency of performing predistortion training can be improved.

The following describes a manner in which the first device obtains the foregoing information.

Manner 1:

The second device sends the foregoing information to the first device. Correspondingly, the first device receives the foregoing information from the second device. It should be understood that, the second device may send the foregoing information to the first device via one or more pieces of signaling (for example, RRC signaling). This is not limited in this application.

For the interval range of each of the plurality of intervals, the second device may send information #A to the first device, where the information #A indicates an endpoint of each of the plurality of intervals (which may also be referred to as a boundary of the interval).

For example, the information #A includes a value of each endpoint; or the information #A includes a value of a 1st endpoint (a starting endpoint) in a plurality of endpoints and an interval length of each of the intervals.

For example, if each of the plurality of intervals has a same length, the information #A may include only a quantity of the intervals. The first device may determine the interval range of each of the intervals based on the quantity of the intervals, and values that are of the 1st endpoint and a last endpoint in the plurality of endpoints and that are preconfigured in the first device.

For example, the information #A may include length information of each of the plurality of intervals. The first device may determine the interval range of each of the intervals based on the length of each of the intervals and the value that is of the 1st endpoint in the plurality of endpoints and that is preconfigured in the first device.

Manner 2:

The foregoing information is specified in a protocol.

S202: The first device obtains a first reference signal based on the configuration information of the reference signal.

In other words, the first device reconstructs the first reference signal based on the configuration information of the reference signal.

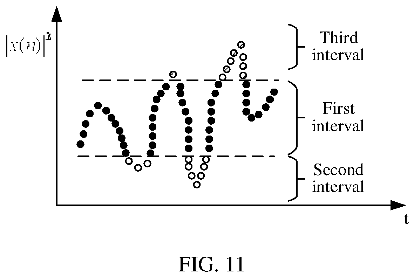

The reconstructed reference signal is a signal before amplification performed by the at least one PA. Therefore, the reconstructed reference belongs to a "pre-PA signal". FIG. 11 shows a plurality of sampling points of the pre-PA signal. In other words, the first reference signal may include a plurality of sampling points.

It should be understood that, a case in which the first device reconstructs the first reference signal (reconstructs the pre-PA signal) based on the configuration information of the reference signal does not mean that the first device needs to reconstruct the first reference signal based on all information in the configuration information of the reference signal. For example, the first device may reconstruct the first reference signal based on a part of information in the configuration information of the reference signal.

In a manner, the first device may reconstruct the first reference signal based on the time-frequency resource information of the reference signal and the sequence information of the reference signal. For example, this process may include the following steps.

Step 1: The first device determines a generation sequence of the reference signal based on the sequence information of the reference signal.

For example, the generation sequence may be a known reference sequence of a sequence such as Zadoff-Chu (ZC) or Gold.

Step 2: The first device performs subcarrier mapping based on the time-frequency resource information of the reference signal.

Step 3: The first device performs inverse fast Fourier transform (inverse fast Fourier transform, IFFT) on a signal obtained by performing resource mapping.

Step 4: The first device performs upsampling on an OFDM (or a DFT-s-OFDM) signal.

Optionally, in step 5, the first device processes an upsampled signal based on a filter parameter. The filter parameter is a filter parameter used when the second device filters the reference signal.

Through the foregoing steps, the first device may reconstruct the first reference signal.

S203: The second device performs power amplification on the first reference signal based on the at least one PA, where at least one corresponding reference signal is obtained through power amplification on the first reference signal.

Alternatively, the first reference signal includes a plurality of reference signals, and at least one corresponding reference signal is obtained through power amplification on each of the plurality of reference signals.

For example, if the at least one PA is one PA, one corresponding reference signal is obtained through power amplification on the first reference signal.

For example, if the at least one PA is a plurality of PAs, a plurality of corresponding reference signals are obtained through power amplification on the first reference signal. It should be understood that, the plurality of PAs are in one-to-one correspondence with the plurality of reference signals. For example, if the second device performs power amplification on the first reference signal based on five PAs, five corresponding reference signals are obtained through power amplification on the first reference signal.

S204: The second device sends, to the first device, the at least one corresponding reference signal obtained through power amplification on the first reference signal in S203. Correspondingly, the first device receives the reference signal from the second device, to obtain a second reference signal.

Specifically, the first device may receive the reference signal based on the configuration information of the reference signal obtained in S201.

The second reference signal obtained by the first device is a reference signal obtained through amplification by the at least one PA. The second reference signal belongs to a "post-PA signal".

In a possible case, if the at least one PA is one PA, the second reference signal obtained by the first device is a reference signal obtained through amplification by the PA.

In another possible case, if the at least one PA is a plurality of PAs, the second reference signal obtained by the first device is a reference signal obtained by combining a plurality of reference signals obtained through amplification by the plurality of PAs.

It should be understood that, a case in which the first device receives the reference signal (post-PA signal) based on the configuration information of the reference signal does not mean that the first device needs to receive the reference signal based on all information in the configuration information of the reference signal. For example, the first device may receive the reference signal based on a part of information in the configuration information of the reference signal.

For example, the first device may receive the reference signal based on the time-frequency resource information of the reference signal and the antenna port information of the reference signal that are obtained in S201.

In addition, a sequence of reconstructing the pre-PA signal by the first device and receiving the post-PA signal by the first device is not limited in this application. In a case, the first device may first reconstruct the pre-PA signal, and then receive the post-PA signal. In another case, the first device may first receive the post-PA signal, and then reconstruct the pre-PA signal. In still another case, reconstructing the pre-PA signal and receiving the post-PA signal may be synchronously performed.

S205: The first device determines, based on a predistortion model parameter of a first interval, the first reference signal, and the second reference signal, a predistortion coefficient of the first interval.

The following describes this process in detail.

Step 1: The first device obtains first sampling point information based on the first reference signal, where the first sampling point information is sampling point information belonging to the first interval.

Specifically, the first device may determine, based on the interval range of each of the plurality of intervals obtained in S201, an interval to which each of a plurality of sampling points included in the first reference signal belongs. In other words, the first device may determine instantaneous power of the sampling point of the pre-PA signal, and determine, based on the instantaneous power of the sampling point, the interval to which the sampling point belongs.

Therefore, the first device may obtain the first sampling point information. As shown in FIG. 11, a plurality of sampling points in the first interval may be discontinuous in time domain.

Step 2: The first device obtains second sampling point information based on the second reference signal, where the second sampling point information is sampling point information corresponding to the first sampling point information.

It should be understood that, the first device may determine sampling points that are in the first interval and that are in the plurality of sampling points of the pre-PA signal, and further determine a plurality of corresponding sampling points of the post-PA signal from the second reference signal obtained in S204 and based on position information (for example, sequence position information) of the sampling points that are of the pre-PA signal and that are in the first interval.

For example, three sampling points (denoted as a sampling point #1 to a sampling point #3) of the first reference signal are in the first interval, and based on sequence position information of the sampling point #1 to the sampling point #3, the first device may separately determine a sampling point #A to a sampling point #C from the second reference signal. The sampling point #A corresponds to the sampling point #1, the sampling point #B corresponds to the sampling point #2, and the sampling point #C corresponds to the sampling point #3. In this example, the first sampling point information corresponds to the sampling point #1 to the sampling point #3, and the second sampling point information corresponds to the sampling point #A to the sampling point #C.

It should be understood that, the sampling points included in the first reference signal are in one-to-one correspondence with the sampling points included in the second reference signal.

Step 3: The first device determines the predistortion coefficient of the first interval based on the predistortion model parameter of the first interval, the first sampling point information, and the second sampling point information. For example, in this embodiment of this application, the predistortion coefficient may be calculated based on an indirect learning structure.

The following describes a process in which the first device performs predistortion training to determine the predistortion coefficient of the first interval. It should be understood that, a manner in which the first device determines a predistortion coefficient of another interval in the plurality of intervals is similar.

It is assumed that the first sampling point information corresponds to Ns sampling points, where the Ns sampling points are denoted as $\mathbf{x}_s = [x_s(0), x_s(1), \ldots, x_s(N_S-1)]^T$. Relative positions of the Ns sampling points in the plurality of sampling points included in the first reference signal are denoted as $\mathbf{l}_s = [l_s(0), l_s(1), \ldots, l_s(N_S-1)]^T$. Further, the first device may determine Ns sampling points in the second reference signal based on the relative positions, where the Ns sampling points are denoted as $\mathbf{r}_s = [r_s(0), r_s(1), \ldots, r_s(N_S-1)]^T$. A predistortion model used for performing predistortion training is an MP model.

Because a pre-inverse model of power amplification is equivalent to a post-inverse model of power amplification, Formula (1) may be obtained:

$$ x_s(n) = \sum_{k=1}^{k_s} \sum_{m=0}^{M-1} c_{k,m}^s \left| r_s(n-m) \right|^{k-1} r_s(n-m) \quad \text{(Formula (1))}, $$

where a value of n ranges from 0 to $N_S$-1.

$k_s$ is a highest non-linear order of the first interval, M is a memory depth of the first interval, $c_{k,m}^s$ is a to-be-estimated predistortion coefficient, a value of k is an integer ranging from 1 to $k_s$, a value of m is an integer ranging from 0 to M-1, and a value of s is related to a position of the first interval in the plurality of intervals. For example, if the first interval is a 2nd interval that is sorted in ascending order in the plurality of intervals, the value of s is 2.

In addition, $c_{k,m}^s \left| r_s(n-m) \right|^{k-1} r_s(n-m)$ in Formula (1) is referred to as a polynomial basis function.

That is, $\phi_{k,m}(r_s) = c_{k,m}^s \left| r_s(n-m) \right|^{k-1} r_s(n-m)$.

Formula (2) may be obtained by writing a polynomial basis function in $\mathbf{r}_s$ into a matrix form.

$$\mathbf{R}_s = [\phi_{1,0}(\mathbf{r}_s), \phi_{2,0}(\mathbf{r}_s), \cdots, \phi_{k,m}(\mathbf{r}_s), \cdots, \phi_{K_S,(M-1)}(\mathbf{r}_s)] \quad \text{(Formula (2))}$$

$$\phi_{k,m}(\mathbf{r}_s) = [|r_s(0-m)|^{k-1} r_s(0-m), |r_s(1-m)|^{k-1} r_s(1-m), \cdots, |r_s(N_s-1-m)|^{k-1} r_s(N_s-1-m)]^T$$

An estimated value of the predistortion coefficient of the first interval may be obtained based on an algorithm such as a least square method, a least mean square method, or a recursive least square method.

For the estimated value that is of the predistortion coefficient of the first interval and that is obtained based on the least square method, refer to the following Formula.

$$\hat{c}_s = \arg\min_{c_s} \|\mathbf{x}_s - \mathbf{R}_s c_s\|_2^2 = (\mathbf{R}_s^H \mathbf{R}_s)^{-1} \mathbf{R}_s^H \mathbf{x}_s$$

Similarly, the first device may determine the predistortion coefficient of the another interval in the plurality of intervals. For a specific process, refer to the foregoing step 1 to step 3. Details are not described herein again.

For example, the first device may determine, based on a predistortion model parameter of a second interval in the plurality of intervals, the first reference signal, and the second reference signal, a predistortion coefficient of the second interval. The first device may determine, based on a predistortion model parameter of a third interval in the plurality of intervals, the first reference signal, and the second reference signal, a predistortion coefficient of the third interval.

For example, the first interval corresponds to a 2nd segment in FIG. 9(a), the highest non-linear order of the first interval $k_s$ is equal to 3, and the memory depth M is equal to 4. The predistortion coefficient $c_{k,m}^s$ that is of the first interval and that is determined by the first device may be shown in Table 1.

If the second interval corresponds to a 1st segment in FIG. 9(a), a highest non-linear order of the second interval is 2, and a memory depth M is equal to 4, the predistortion coefficient that is of the second interval and that is determined by the first device is shown in Table 2.

If the third interval corresponds to a 3rd segment in FIG. 9(a), a highest non-linear order of the third interval is 5, and a memory depth M is equal to 4, the predistortion coefficient that is of the third interval and that is determined by the first device is shown in Table 3.

Table 1

| $c_{1,0}^2$ | $c_{1,1}^2$ | $c_{1,2}^2$ | $c_{1,3}^2$ |
|---|---|---|---|
| $c_{2,0}^2$ | $c_{2,1}^2$ | $c_{2,2}^2$ | $c_{2,3}^2$ |
| $c_{3,0}^2$ | $c_{3,1}^2$ | $c_{3,2}^2$ | $c_{3,3}^2$ |

Table 2

| $c_{1,0}^1$ | $c_{1,1}^1$ | $c_{1,2}^1$ | $c_{1,3}^1$ |
|---|---|---|---|
| $c_{2,0}^1$ | $c_{2,1}^1$ | $c_{2,2}^1$ | $c_{2,3}^1$ |

Table 3

| $c_{1,0}^3$ | $c_{1,1}^3$ | $c_{1,2}^3$ | $c_{1,3}^3$ |
|---|---|---|---|
| $c_{2,0}^3$ | $c_{2,1}^3$ | $c_{2,2}^3$ | $c_{2,3}^3$ |
| $c_{3,0}^3$ | $c_{3,1}^3$ | $c_{3,2}^3$ | $c_{3,3}^3$ |

(continued)

| | | | |
|---|---|---|---|
| $c_{4,0}^{3}$ | $c_{4,1}^{3}$ | $c_{4,2}^{3}$ | $c_{4,3}^{3}$ |
| $c_{5,0}^{3}$ | $c_{5,1}^{3}$ | $c_{5,2}^{3}$ | $c_{5,3}^{3}$ |

S206: The first device sends the predistortion coefficient of the first interval to the second device.

Similarly, the first device may send the predistortion coefficient of the another interval in the plurality of intervals to the second device.

Optionally, in a manner, the first device may send all predistortion coefficients that are of the intervals and that are determined by the first device to the second device.

For example, the first device may send all content in the foregoing Table 1, Table 2, and Table 3 to the second device.

Optionally, in another manner, because a predistortion coefficient of an odd-numbered term can be well fitted to the predistortion model, the first device may report only a predistortion coefficient whose non-linear order is an odd number to the second device. The second device may perform predistortion processing only based on the predistortion coefficient whose non-linear order is the odd number. Based on this reporting manner, reporting overheads of the first device can be reduced.

By using the foregoing Table 1, Table 2, and Table 3 as an example, the first device may report a 1st row and a 3rd row in Table 1 to the second device (referring to Table 1-1), report a 1st row in Table 2 to the second device (referring to Table 2-1), and report a 1st row, a 3rd row, and a 5th row in Table 3 to the second device (referring to Table 3-1).

Table 1-1

| | | | |
|---|---|---|---|
| $c_{1,0}^{2}$ | $c_{1,1}^{2}$ | $c_{1,2}^{2}$ | $c_{1,3}^{2}$ |
| $c_{3,0}^{2}$ | $c_{3,1}^{2}$ | $c_{3,2}^{2}$ | $c_{3,3}^{2}$ |

Table 2-1

| | | | |
|---|---|---|---|
| $c_{1,0}^{1}$ | $c_{1,1}^{1}$ | $c_{1,2}^{1}$ | $c_{1,3}^{1}$ |

Table 3-1

| | | | |
|---|---|---|---|
| $c_{1,0}^{3}$ | $c_{1,1}^{3}$ | $c_{1,2}^{3}$ | $c_{1,3}^{3}$ |
| $c_{3,0}^{3}$ | $c_{3,1}^{3}$ | $c_{3,2}^{3}$ | $c_{3,3}^{3}$ |
| $c_{5,0}^{3}$ | $c_{5,1}^{3}$ | $c_{5,2}^{3}$ | $c_{5,3}^{3}$ |

S207: The second device performs predistortion processing on a fifth reference signal based on the predistortion coefficient of the first interval.

Power of the fifth reference signal is in the first interval, the fifth reference signal is a signal before amplification performed by the at least one PA, and the fifth reference signal belongs to a "pre-PA signal".

In a manner, the second device may perform instantaneous power detection on the pre-PA signal, to determine instantaneous power of the pre-PA signal, and select a corresponding predistortion coefficient based on the instantaneous power of the pre-PA signal, to perform predistortion processing.

For example, if a signal input to a DPD module is $t_s(n)$, a signal output from the DPD module is $x_s(n)$, and the model used for performing predistortion processing is an MP model,

$$x_s(n) = \sum_{k=1}^{K_s} \sum_{m=0}^{M-1} c_{k,m}^{s} \left| t_s(n-m) \right|^{k-1} t_s(n-m)$$

.

$c_{k,m}^s$ is a predistortion coefficient determined based on power of $t_s(n)$.

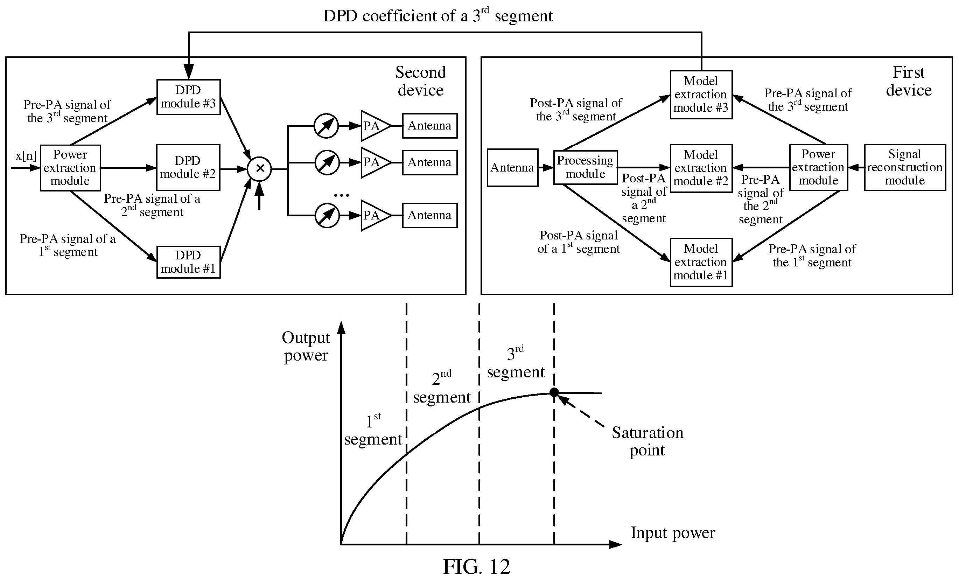

As shown in FIG. 12, a signal reconstruction (signal reconstruction) module of the first device is configured to reconstruct the pre-PA signal; a power extraction (power extraction) module is configured to determine power of the reconstructed pre-PA signal; and a model extraction (model extraction) module is configured to: determine a DPD coefficient based on the pre-PA signal and the post-PA signal, and feed back the DPD coefficient to the second device. A power extraction module of the second device is configured to perform power detection on the pre-PA signal, and a DPD module is configured to perform predistortion processing on the pre-PA signal.

In FIG. 12, the non-linear curve of the PA is divided into three segments. For example, a model extraction module #3 of the first device is configured to: determine a DPD coefficient of a 3rd segment based on a pre-PA signal of the 3rd segment and a post-PA signal of the 3rd segment (namely, a post-PA signal corresponding to the pre-PA signal of the 3rd segment), and feed back the DPD coefficient of the 3rd segment to the second device. Subsequently, the power extraction module of the second device may determine power of the pre-PA signal. If the power of the pre-PA signal is in an interval corresponding to the 3rd segment, the pre-PA signal is input to a DPD module #3, and the DPD module #3 performs predistortion processing on the pre-PA signal based on the DPD coefficient of the 3rd segment.

It can be learned from the foregoing descriptions of the method 200 that, in comparison with a case in which the first device sends a predistortion coefficient of the entire segment of the non-linear curve of the PA to the second device, according to this embodiment of this application, the non-linear curve of the PA is divided into the plurality of intervals (plurality of segments) based on the magnitude of the input power, and the first device may determine and send predistortion coefficients of the plurality of intervals to the second device at a granularity of an interval. In this way algorithm complexity of performing predistortion training performed by the first device can be reduced, and accuracy of the predistortion coefficient obtained by the first device through calculation can also be improved, to improve performance of performing predistortion processing by the second device on the reference signal.

In addition, optionally, the second device may have a plurality of digital channels. When the first device performs predistortion training on a first digital channel in the plurality of digital channels, the second device may close a digital channel adjacent to the first digital channel. For example, the second device may close a digital channel other than the first digital channel, to avoid mutual interference between the digital channels and improve training performance.

The following describes a second technical problem of this application.

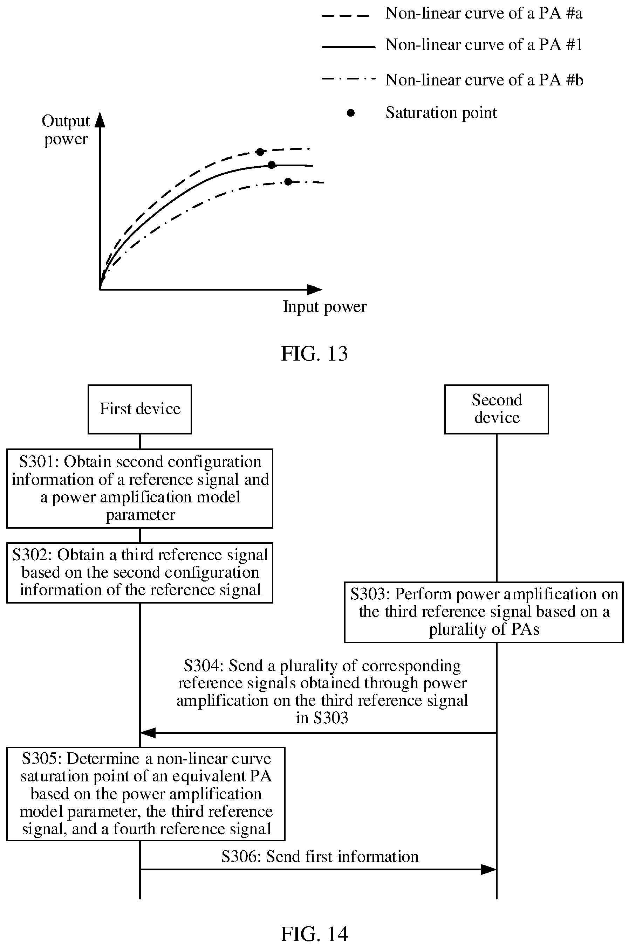

In this application, one digital channel may correspond to a plurality of PAs (for example, a PA #a and a PA #b), and an equivalent PA of the PA #a and the PA #b is denoted as a PA #1. As shown in FIG. 13, a non-linear curve saturation point of the PA #1 may be different from a non-linear curve saturation point of the PA #a, and the non-linear curve saturation point of the PA #1 may also be different from a non-linear curve saturation point of the PA #b. If predistortion training is performed based on the non-linear curve saturation point of the PA #a or the non-linear curve saturation point of the PA #b, accuracy of an obtained predistortion coefficient is reduced.

To resolve this technical problem, this application provides a method 300. In the method 300, a PA #1 is an equivalent PA of a plurality of PAs, and the method 300 is for determining a non-linear curve saturation point of the equivalent PA.

Specifically, as shown in FIG. 14, the method 300 includes the following steps.

S301: A first device obtains second configuration information of a reference signal and a power amplification model parameter.

For a type of information included in the second configuration information of the reference signal, refer to the descriptions in S201. It should be understood that, the configuration information that is of the reference signal and that is obtained by the first device in S201 and the second configuration information that is of the reference signal and that is obtained in S301 may be different.

The second configuration information of the reference signal includes second time-frequency resource information of the reference signal and sequence information of the reference signal. Optionally, the second configuration information of the reference signal further includes one or more of the following: type information of the reference signal, antenna port information of the reference signal, bandwidth information of the reference signal, and a filter parameter.

The predistortion model parameter includes a power amplification model type and a power amplification model order.

The power amplification model type may be a polynomial model, an MP model, or a GMP model. The power amplification model order includes a non-linear order, a memory depth, and a cross term length, which may be respectively represented by K, M, and G.

In addition, for a manner in which the first device obtains the second configuration information of the reference signal and the power amplification model parameter, refer to S201. Details are not described herein again.

S302: The first device obtains a third reference signal based on the second configuration information of the reference signal.

In other words, the first device reconstructs the third reference signal based on the second configuration information of the reference signal.

The third reference signal is a signal before amplification performed by the plurality of PAs. Therefore, the third reference signal belongs to a "pre-PA signal".

In a manner, the first device may reconstruct the third reference signal based on a part of the information in the second configuration information. For example, the first device may reconstruct the third reference signal based on the sequence information of the reference signal and the second configuration information of the reference signal. For this process, refer to step 1 to step 5 in S202.

S303: A second device performs power amplification on the third reference signal based on the plurality of PAs. A plurality of corresponding reference signals are obtained through power amplification on the third reference signal.

It should be understood that, the plurality of PAs are in one-to-one correspondence with the plurality of reference signals. For example, if the second device performs power amplification on the third reference signal based on five PAs, five corresponding reference signals are obtained through power amplification on the third reference signal.

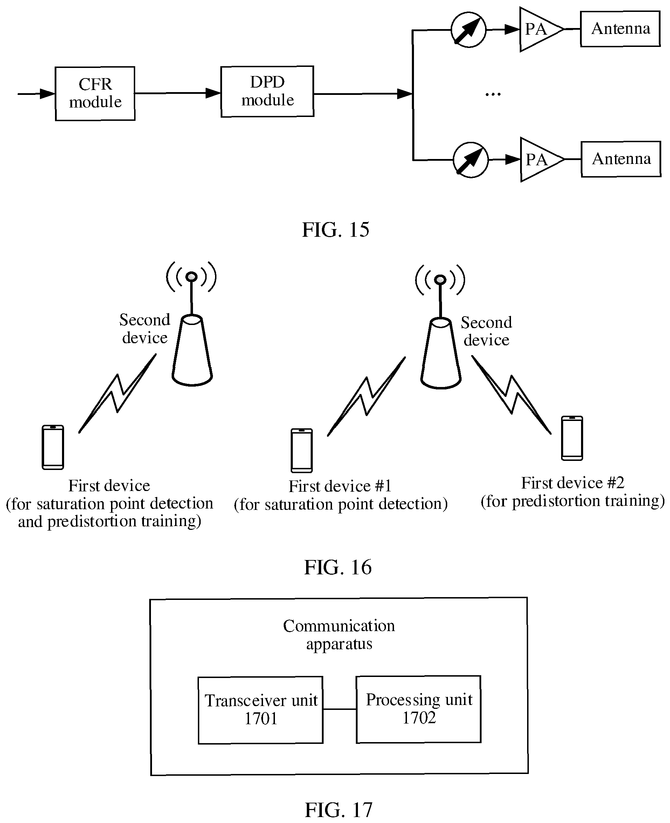

Optionally, the second device skips performing CFR processing on the third reference signal. For example, for a relationship between a CFR module and another module, refer to FIG. 15.

According to this embodiment of this application, the second device skips performing CFR processing on the third reference signal, so that power of the reference signal can more easily reach power corresponding to the non-linear curve saturation point of the equivalent PA, and a probability that the first device successfully detects the non-linear curve saturation point of the equivalent PA can be improved.

S304: The second device sends, to the first device, the corresponding reference signals obtained through power amplification on the third reference signal in S303. Correspondingly, the first device receives the reference signals from the second device, to obtain a fourth reference signal.

It should be understood that, the fourth reference signal is a reference signal obtained by combining the plurality of reference signals. In other words, the fourth reference signal is a signal obtained through amplification performed by the plurality of PAs on the third reference signal. The fourth reference signal belongs to a "post-PA signal".

In a manner, the first device may obtain the fourth reference signal based on a part of the information in the second configuration information. For example, the first device may obtain the fourth reference signal based on the second time-frequency resource of the reference signal and the antenna port information of the reference signal that are obtained in S301.

S305: The first device determines the non-linear curve saturation point of the equivalent PA based on the power amplification model parameter, the third reference signal, and the fourth reference signal.

The following describes S305 in different cases.

Case 1:

The first device may directly determine the non-linear curve saturation point of the equivalent PA based on the third reference signal and the fourth reference signal.

Case 2:

Because the fourth reference signal may be affected by noise or a multipath, a non-linear curve saturation point that is of the equivalent PA and that is directly determined based on the third reference signal and the fourth reference signal may be inaccurate. Therefore, to reduce impact of the noise and the multipath on the calculation result, this application provides the following manner.

Specifically, the first device may train a PA model based on the power amplification model parameter, the third reference signal, and the fourth reference signal, to obtain a model coefficient (or may be referred to as a PA coefficient, a power amplification coefficient, or the like) of the equivalent PA. Further, the first device determines a fourth reference signal #2 based on the model coefficient of the equivalent PA and the third reference signal. Further, the first device determines the non-linear curve saturation point of the equivalent PA based on the third reference signal and the fourth reference signal #2.

It should be understood that, impact of the noise and the multipath on the fourth reference signal #2 is lower than those on the fourth reference signal.

The following describes a process in which the first device calculates the model coefficient of the equivalent PA.

During PA model training, the first device does not know the non-linear curve saturation point of the equivalent PA. Therefore, in a manner, the first device may calculate the PA coefficient based on a single-segment model.

It is assumed that the power amplification model type is an MP model, and the third reference signal includes N sampling points, where the N sampling points are denoted as $\mathbf{x} = [x(0),x(1),......,x(N-1)]^T$. Correspondingly, the fourth reference signal also includes N sampling points, where the N sampling points are denoted as $\tilde{\mathbf{r}} = [\tilde{r}(0), \tilde{r}(1), \cdots, \tilde{r}(N-1)]^T$, a memory depth is M, and a highest non-linear order is K. The sampling points included in the third reference signal are in one-to-one correspondence with the sampling points included in the fourth reference signal.

A relationship between $x(n)$ and $\tilde{r}(n)$ is shown in Formula 3:

$$\tilde{r}(n) = \sum_{m=0}^{M-1} \sum_{k=1}^{K} b_{k,m} \left| x(n-m) \right|^{k-1} x(n-m) \quad \text{(Formula 3),}$$

where a value of n ranges from 0 to $N$-1.

An estimated value of the model coefficient of the equivalent PA may be obtained based on an algorithm such as a least square method, a least mean square method, or a recursive least square method. The estimated value that is of the model coefficient of the equivalent PA and that is obtained based on the least square method is shown in Formula 4.

$$\hat{\mathbf{b}} = \arg\min_{b} \left\| \tilde{\mathbf{r}} - \mathbb{W}\mathbf{b} \right\|_2^2 = (\mathbb{W}^H \mathbb{W})^{-1} \mathbb{W}^H \tilde{\mathbf{r}} \quad \text{(Formula 4)}$$

W is a matrix formed by a basis function of the third reference signal.

$$\mathbb{W} = \left[ \phi_{1,0}(\mathbf{x}), \phi_{2,0}(\mathbf{x}), \cdots, \phi_{k,m}(\mathbf{x}), \cdots \phi_{K,M-1}(\mathbf{x}) \right]$$

$$\phi_{k,m}(\mathbf{x}) = \left[ \left| x(0-m) \right|^{k-1} x(0-m), \left| x(1-m) \right|^{k-1} x(1-m), \cdots, \left| x(N-1-m) \right|^{k-1} x(N-1-m) \right]^T$$

For example, the highest non-linear order K is equal to 3 and the memory depth M is equal to 3. The model coefficient of the equivalent PA may be shown in Table 4. $b_{k,m}$ is a model coefficient corresponding to a non-linear order k and a memory depth m. For example, $b_{1,0}$ is a model coefficient corresponding to a non-linear order 1 and a memory depth 0.

Table 4

| | | |
|---|---|---|
| $b_{1,0}$ | $b_{1,1}$ | $b_{1,2}$ |
| $b_{2,0}$ | $b_{2,1}$ | $b_{2,2}$ |
| $b_{3,0}$ | $b_{3,1}$ | $b_{3,2}$ |

The non-linear curve saturation point of the equivalent PA is determined according to the method in the foregoing Case 2, so that impact of the noise and the multipath on the calculation result can be reduced, to improve accuracy of the calculation result.

In addition, optionally, in the foregoing Case 1 and Case 2, when the first device does not detect the non-linear curve saturation point of the equivalent PA, the first device may send second information to the second device, where the second information indicates to increase power of the reference signal before amplification performed by the plurality of PAs. Correspondingly, the second device increases, based on the second information, the power of the reference signal before amplification performed by the plurality of PAs. In a manner, an increase amount (an increment) of the power of the pre-PA signal may be specified in a protocol.

S306: The first device sends first information to the second device. Correspondingly, the second device receives the first information.

For example, the first information may be carried in uplink control information (uplink control information, UCI) or RRC signaling.

The first information includes information about the non-linear curve saturation point of the equivalent PA. For example, the first information includes instantaneous input power of the non-linear curve saturation point of the equivalent PA.

Optionally, in S305, after obtaining the model coefficient of the equivalent PA through calculation, the first device may not continue to determine the non-linear curve saturation point of the equivalent PA. The first device may send the first information to the second device. In this case, the first information includes the model coefficient of the equivalent PA. In this case, the second device may determine the fourth reference signal #2 based on the model coefficient that is of the equivalent PA and that is obtained through estimation and the third reference signal. Further, the second device determines the non-linear curve saturation point of the equivalent PA based on the third reference signal and the fourth reference signal #2.

According to this embodiment of this application, considering that the non-linear curve saturation point of the equivalent PA may be different from non-linear curve saturation points of the plurality of PAs, the first device may determine the non-linear curve saturation point of the equivalent PA, and send the first information to the second device. Based on this, subsequent division of a plurality of intervals can be more accurate, and performance of performing predistortion processing by the second device on the reference signal can be improved.

It should be understood that, the method 300 may exist independently, or may be combined with the method 200 (for example, S201 to S207 may continue to be performed after S306). This is not limited in this application.

In addition, as shown in FIG. 16, the first device in the method 200 and the first device in the method 300 may be a same device, or may be different devices. In other words, saturation point detection and predistortion training may be completed by a same device, or may be completed by different devices. This is not limited in this application.

According to the foregoing method, FIG. 17 shows a communication apparatus according to an embodiment of this application. The communication apparatus includes a transceiver unit 1701 and a processing unit 1702.

The transceiver unit 1701 may be configured to implement corresponding information sending and receiving functions. The transceiver unit 1701 may also be referred to as a communication interface or a communication unit. The processing unit 1702 may be configured to perform a processing operation.

For example, the apparatus further includes a storage unit. The storage unit may be configured to store instructions and/or data. The processing unit 1702 may read the instructions and/or the data in the storage unit, to cause the apparatus to implement an action of the apparatus in the foregoing method embodiments.

In a first implementation, the apparatus may be the first device in the foregoing embodiments, or may be a component (for example, a chip) of the first device. The transceiver unit and the processing unit may be configured to implement related operations of the first device in the foregoing method embodiments. For example, the transceiver unit is configured to implement S201, S204, and S206, or is configured to implement S301, S304, and S306. For example, the processing unit is configured to implement S202 and S205, or is configured to implement S302.

In a second implementation, the apparatus may be the second device in the foregoing embodiments, or may be a component (for example, a chip) of the second device. The transceiver unit and the processing unit may be configured to implement related operations of the second device in the foregoing method embodiments. For example, the transceiver unit is configured to implement S204 and S206, or is configured to implement S304 and S306. For example, the processing unit is configured to implement S203 and S207, or is configured to implement S303.

It should be understood that, a specific process of performing the foregoing corresponding step by each unit is described in detail in the foregoing method embodiments. For brevity, details are not described herein again.

It should also be understood that, the apparatus herein is embodied in a form of a functional unit. The term "unit" herein may refer to an application-specific integrated circuit (application-specific integrated circuit, ASIC), an electronic circuit, a processor (for example, a shared processor, a dedicated processor, or a group processor) configured to execute one or more software or firmware programs, a memory, a merged logic circuit, and/or another suitable component that supports the described functions.

The foregoing communication apparatus has functions of implementing corresponding steps performed by the apparatuses in the foregoing methods. The functions may be implemented by hardware, or may be implemented by executing corresponding software by hardware. The hardware or the software includes one or more modules corresponding to the foregoing functions. For example, a transceiver unit may be replaced with a transceiver (for example, a sending unit in the transceiver unit may be replaced with a transmitter, and a receiving unit in the transceiver unit may be replaced with a receiver) and another unit, for example, a processing unit may be replaced with a processor, to separately perform sending and receiving operations and a related processing operation in the method embodiments.

In addition, the transceiver unit 1701 may alternatively be a transceiver circuit (for example, the transceiver circuit may include a receiving circuit and a sending circuit), and the processing unit may be a processing circuit.

It should be noted that, the apparatus in FIG. 17 may be the apparatus in the foregoing method embodiments, or may be a chip or a chip system, for example, a system-on-a-chip (system-on-a-chip, SoC). The transceiver unit may be an input/output circuit or a communication interface. The processing unit is a processor, a microprocessor, or an integrated circuit integrated on the chip. This is not limited herein.

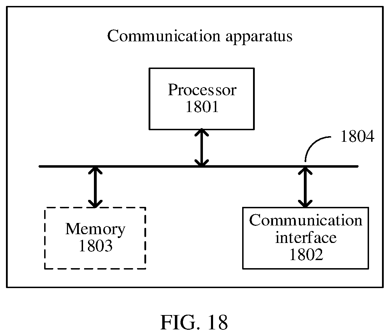

An embodiment of this application further provides a communication apparatus. As shown in FIG. 18, the communication apparatus includes a processor 1801 and a communication interface 1802. The processor 1801 is configured to execute a computer program or instructions stored in a memory 1803, or read data stored in the memory 1803, to perform the methods in the foregoing method embodiments. For example, there are one or more processors 1801. The communication interface 1802 is configured to receive and/or send a signal. For example, the processor 1801 is configured to control the communication interface 1802 to receive and/or send a signal.

For example, as shown in FIG. 18, the communication apparatus may further include the memory 1803, and the memory 1803 is configured to store a computer program or instructions and/or data. The memory 1803 and the processor 1801 may be integrated, or may be separately arranged. Certainly, the communication apparatus may alternatively not include the memory 1803, and the memory 1803 is arranged outside the communication apparatus. For example, there may be one or more memories 1803.

For example, the processor 1801, the communication interface 1802, and the memory 1803 are connected to each other through a bus 1804. The bus 1804 may be a peripheral component interconnect (peripheral component interconnect, PCI) bus, an extended industry standard architecture (extended industry standard architecture, EISA) bus, or the like. The bus 1804 may be classified into an address bus, a data bus, a control bus, or the like. For ease of representation, only one thick line is used for representing the bus in FIG. 18, but this does not mean that there is only one bus or only one type of bus.

For example, the processor 1801 is configured to execute the computer program or the instructions stored in the memory 1803.

In a first implementation, the apparatus may be the first device in the foregoing embodiments, or may be a component (for example, a chip) of the first device. The communication interface and the processor may be configured to implement related operations of the first device in the foregoing method embodiments. For example, the communication interface is configured to implement S201, S204, and S206, or is configured to implement S301, S304, and S306. For example, the processor is configured to implement S202 and S205, or is configured to implement S302.

In a second implementation, the apparatus may be the second device in the foregoing embodiments, or may be a component (for example, a chip) of the second device. The communication interface and the processor may be configured to implement related operations of the second device in the foregoing method embodiments. For example, the communication interface is configured to implement S204 and S206, or is configured to implement S304 and S306. For example, the processor is configured to implement S203 and S207, or is configured to implement S303.

It should be understood that, a processor (for example, the processor 1801) mentioned in embodiments of this application may be a central processing unit (central processing unit, CPU), a network processor (network processor, NP), or a combination of the CPU and the NP. The processor may further include a hardware chip. The hardware chip may be an ASIC, a programmable logic device (programmable logic device, PLD), or a combination thereof. The PLD may be a complex programmable logic device (complex programmable logic device, CPLD), a field-programmable logic gate array (field-programmable logic gate array, FPGA), a generic array logic (generic array logic, GAL), or any combination thereof.

It should be further understood that, a memory (for example, the memory 1803) mentioned in embodiments of this application may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache.

A person of ordinary skill in the art may be aware that, in combination with examples described in embodiments disclosed in this specification, units and algorithm steps can be implemented by electronic hardware or a combination of computer software and the electronic hardware. Whether the functions are performed by hardware or software depends on particular applications and design constraints of the technical solutions. A person skilled in the art may use different methods to implement the described functions for each particular application, but it should not be considered that such an implementation goes beyond the scope of this application.

It may be clearly understood by a person skilled in the art that, for the purpose of convenient and brief description, for a specific working process of the foregoing system, apparatuses, and units, refer to a corresponding process in the foregoing method embodiments. Details are not described herein again.

In a plurality of embodiments provided in this application, it should be understood that, the disclosed system, apparatuses, and methods may be implemented in other manners. For example, the apparatus embodiments described above are merely examples. For example, division of the units is merely logical function division. In an actual implementation, there may be another division manner. For example, a plurality of units or components may be combined or integrated into another system, or some features may be ignored or not performed. In addition, displayed or discussed mutual couplings or direct couplings or communication connections may be implemented through some interfaces. The indirect couplings or communication connections between the apparatuses or units may be in electrical, mechanical, or other forms.

Units described as separate components may or may not be physically separate, and components displayed as units may or may not be physical units, to be specific, may be located at one position, or may be distributed on a plurality of network units. A part or all of the units may be selected based on an actual requirement to achieve the objectives of the solutions of embodiments.

In addition, functional units in embodiments of this application may be integrated into one processing unit, or each of the units may exist alone physically, or two or more units may be integrated into one unit.

When the functions are implemented in a form of a software functional unit and sold or used as an independent product, the functions may be stored in a computer-readable storage medium. This application provides a computer-readable storage medium, including a computer program. When the computer program is run on a computer, the computer is caused to perform any one of possible implementations in the foregoing method embodiments.

The technical solutions of this application or a part of the technical solutions may be embodied in a form of a software product. Therefore, this application further provides a computer program product. The computer program product includes a computer program (which may also be referred to as code or instructions). When the computer program is run, a computer is caused to perform any one of possible implementations in the foregoing method embodiments. The computer software product is stored in a storage medium, and includes a plurality of instructions for instructing a computer device (which may be a personal computer, a server, a network device, or the like) to perform all or a part of steps of the methods in embodiments of this application.

The foregoing storage medium includes any medium that can store program code, such as a USB flash drive, a removable hard disk drive, a ROM, a RAM, a magnetic disk, or an optical disc.

Mutual reference may be made to content in embodiments of this application. Unless otherwise stated or there is a logical conflict, terms and/or descriptions in different embodiments are consistent and may be mutually referenced. Technical features in different embodiments may be combined based on an internal logical relationship thereof, to form a new embodiment.

It may be understood that, in embodiments of this application, the first device and/or the second device may perform a part or all of steps in embodiments of this application. These steps or operations are merely examples. In embodiments of this application, other operations or variations of various operations may be further performed. In addition, the steps may be performed in a sequence different from a sequence presented in embodiments of this application, and it is possible that not all operations in embodiments of this application are performed.

**Claims**

1. A communication method, comprising:

   obtaining, by a first device, configuration information of a reference signal, an interval range of each of a plurality of intervals, and a predistortion model parameter of each of the plurality of intervals, wherein the plurality of intervals are power intervals of the reference signal;
   obtaining, by the first device, a first reference signal based on the configuration information;
   receiving, by the first device, a reference signal from a second device, to obtain a second reference signal; and
   determining, by the first device based on a predistortion model parameter of a first interval in the plurality of intervals, the first reference signal, and the second reference signal, a predistortion coefficient of the first interval.

2. The method according to claim 1, wherein
   the obtaining, by the first device, a first reference signal based on the configuration information comprises:
   reconstructing, by the first device, the first reference signal based on the configuration information.

3. The method according to claim 1 or 2, wherein the method further comprises:
   sending, by the first device, the predistortion coefficient of the first interval to the second device.

4. The method according to any one of claims 1 to 3, wherein the method further comprises:
   determining, by the first device based on a predistortion model parameter of a second interval in the plurality of intervals, the first reference signal, and the second reference signal, a predistortion coefficient of the second interval.

5. The method according to any one of claims 1 to 4, wherein
   the determining, by the first device based on a predistortion model parameter of a first interval, the first reference signal, and the second reference signal, a predistortion coefficient of the first interval comprises:

   obtaining, by the first device, first sampling point information based on the first reference signal, wherein the first sampling point information is sampling point information belonging to the first interval;
   obtaining, by the first device, second sampling point information based on the second reference signal, wherein the second sampling point information is sampling point information corresponding to the first sampling point information; and
   determining, by the first device, the predistortion coefficient of the first interval based on the predistortion model parameter of the first interval in the plurality of intervals, the first sampling point information, and the second sampling point information.

6. The method according to any one of claims 1 to 5, wherein the configuration information comprises time-frequency resource information of the reference signal, sequence information of the reference signal, and one or more of the following:

type information of the reference signal, antenna port information of the reference signal, bandwidth information of the reference signal, and a filter parameter, wherein the time-frequency resource information corresponds to the antenna port information.

7. The method according to any one of claims 1 to 6, wherein

the second reference signal is a signal obtained through amplification by at least one PA; and when the at least one PA is one PA, in the plurality of intervals, a largest value of interval endpoints corresponds to a non-linear curve saturation point of the PA; or when the at least one PA is a plurality of PAs, in the plurality of intervals, a largest value of interval endpoints corresponds to a non-linear curve saturation point of an equivalent PA of the plurality of PAs.

8. The method according to any one of claims 1 to 7, wherein

each of the plurality of intervals has a same length; or the plurality of intervals comprise the second interval, and a length of the first interval is different from a length of the second interval.

9. The method according to any one of claims 1 to 8, wherein

the predistortion model parameter of each of the plurality of intervals comprises a non-linear order; and each of the plurality of intervals has a same non-linear order; or the plurality of intervals comprise a third interval, and a non-linear order of the first interval is different from a non-linear order of the third interval.

10. The method according to any one of claims 1 to 9, wherein when the second reference signal is a signal obtained through amplification by the plurality of PAs, the method further comprises:

obtaining, by the first device, second configuration information of the reference signal and a power amplification model parameter; obtaining, by the first device, a third reference signal based on the second configuration information; receiving, by the first device, reference signals from the second device, to obtain a fourth reference signal; determining, by the first device, the non-linear curve saturation point of the equivalent PA of the plurality of PAs based on the power amplification model parameter, the third reference signal, and the fourth reference signal; and sending, by the first device, first information to the second device, wherein the first information comprises information about the non-linear curve saturation point of the equivalent PA.

11. The method according to claim 10, wherein when the first device does not detect the non-linear curve saturation point of the equivalent PA, sending, by the first device, second information to the second device, wherein the second information indicates to increase power of a reference signal before amplification performed by the plurality of PAs.

12. A communication method, comprising:

performing, by a second device, power amplification on a first reference signal based on at least one power amplifier PA; sending, by the second device to a first device, a corresponding reference signal obtained through power amplification on the first reference signal; receiving, by the second device, a predistortion coefficient of a first interval from the first device; and performing, by the second device, predistortion processing on a fifth reference signal based on the predistortion coefficient of the first interval, wherein power of the fifth reference signal is in the first interval, and the fifth reference signal is a signal before power amplification.

13. The method according to claim 12, wherein the method further comprises:

sending, by the second device, configuration information of a reference signal, an interval range of each of a plurality of intervals, and a predistortion model parameter of each of the plurality of intervals to the first device, wherein
the configuration information comprises time-frequency resource information of the reference signal and sequence information of the reference signal, and the plurality of intervals comprise the first interval.

14. The method according to claim 13, wherein the configuration information further comprises one or more of the following:

type information of the reference signal, antenna port information of the reference signal, bandwidth information of the reference signal, and a filter parameter, wherein
the time-frequency resource information corresponds to the antenna port information.

15. The method according to claim 13 or 14, wherein

each of the plurality of intervals has a same length; or
the plurality of intervals comprise a second interval, and a length of the first interval is different from a length of the second interval.

16. The method according to any one of claims 13 to 15, wherein

the at least one PA is one PA, and in the plurality of intervals, a largest value of interval endpoints corresponds to input power of a non-linear curve saturation point of the PA; or
the at least one PA is a plurality of PAs, and in the plurality of intervals, a largest value of interval endpoints corresponds to input power of a non-linear curve saturation point of an equivalent PA of the plurality of PAs.

17. The method according to any one of claims 13 to 16, wherein

the predistortion model parameter of each of the plurality of intervals comprises a non-linear order; and
each of the plurality of intervals has a same non-linear order; or the plurality of intervals comprise a third interval, and a non-linear order of the first interval is different from a non-linear order of the third interval.

18. The method according to any one of claims 12 to 17, wherein when the at least one PA is the plurality of PAs, the method further comprises:

sending, by the second device, second configuration information of the reference signal and a PA model parameter to the first device;
performing, by the second device, power amplification on a third reference signal based on the plurality of PAs;
sending, by the second device to the first device, a corresponding reference signal obtained through power amplification on the third reference signal; and
receiving, by the second device, first information from the first device, wherein the first information comprises information about the non-linear curve saturation point of the equivalent PA of the plurality of PAs.

19. The method according to claim 18, wherein the method further comprises:
skipping, by the second device, performing crest factor reduction CFR processing on the third reference signal.

20. The method according to claim 18 or 19, wherein the method further comprises:

receiving, by the second device, second information from the first device, wherein the second information indicates to increase power of a reference signal before amplification performed by the plurality of PAs; and
increasing, by the second device based on the second information, the power of the reference signal before amplification performed by the plurality of PAs.

21. A communication apparatus, comprising a unit configured to perform the methods according to any one of claims 1 to 20.

22. A communication apparatus, comprising a communication interface and a processor, wherein the communication interface is configured to output and/or input a signal, and the processor is configured to execute a computer program or instructions stored in a memory, to cause the communication apparatus to perform the method according to any one of claims 1 to 11, or to cause the communication apparatus to perform the method according to any one of claims 12 to 20.

23. The communication apparatus according to claim 22, wherein the communication apparatus further comprises the memory.

24. A computer-readable storage medium, comprising a computer program or instructions, wherein when the computer program or the instructions are run on a computer, the computer is caused to perform the method according to any one of claims 1 to 11, or the computer is caused to perform the method according to any one of claims 12 to 20.

25. A computer program product, comprising instructions, wherein when the instructions are run on a computer, the computer is caused to perform the method according to any one of claims 1 to 11, or the computer is caused to perform the method according to any one of claims 12 to 20.

FIG. 1

FIG. 2

DPD module → Digital-to-analog conversion module → PA → Antenna

Pre-PA signal

DPD coefficient

Tx #1

Model extraction module ← Post-PA signal

...

DPD module → Digital-to-analog conversion module → PA → Antenna

Pre-PA signal

DPD coefficient

Tx #N

Model extraction module ← Post-PA signal

FIG. 3

Baseband

Intermediate frequency module → Digital-to-analog conversion module → × → PA ...

...

Intermediate frequency module → Digital-to-analog conversion module → × → PA ...

FIG. 4

FIG. 5

```
┌─────────────┐                              ┌─────────┐
│ First device│                              │ Second  │
│             │                              │ device  │
└──────┬──────┘                              └────┬────┘
┌──────┴─────────────────────────┐                │
│ S201: Obtain configuration      │                │
│ information of a reference       │                │
│ signal, an interval range of     │                │
│ each of a plurality of intervals,│                │
│ and a predistortion model        │                │
│ parameter of each of the         │                │
│ plurality of intervals           │                │
└──────┬─────────────────────────┘                │
┌──────┴─────────────────────────┐                │
│ S202: Obtain a first reference   │                │
│ signal based on the configuration│                │
│ information of the reference      │                │
│ signal                           │                │
└──────┬─────────────────────────┘                │
       │       ┌──────────────────────────────────┴────────┐
       │       │ S203: Perform power amplification on the    │
       │       │ first reference signal based on at least    │
       │       │ one PA                                       │
       │       └──────────────────────────────────┬────────┘
       │  S204: Send a corresponding reference      │
       │  signal obtained through power             │
       │◄─ amplification on the first reference ─────┤
       │  signal in S203                            │
┌──────┴─────────────────────────┐                │
│ S205: Determine, based on a      │                │
│ predistortion model parameter    │                │
│ of a first interval, the first    │                │
│ reference signal, and a second    │                │
│ reference signal, a predistortion │                │
│ coefficient of the first interval │                │
└──────┬─────────────────────────┘                │
       │  S206: Send the predistortion              │
       ├─ coefficient of the first interval ────────►│
       │       ┌──────────────────────────────────┴────────┐
       │       │ S207: Perform predistortion processing on a │
       │       │ fifth reference signal based on the         │
       │       │ predistortion coefficient of the first      │
       │       │ interval                                    │
       │       └──────────────────────────────────┬────────┘
       │                                            │
```

FIG. 6

Position occupied by
a reference signal in
time domain

(a)

Slot 0 1 2 3 4 5 6 7 8 9 10

(b)

Slot 0 1 2 3 4 5 6 7 8 9 10

(c)

Slot 0 1 2 3 4 5 6 7 8 9 10

FIG. 7

Plurality
of REs

Plurality
of REs

Time-frequency
position occupied by
another signal

Time-frequency
position occupied by
a reference signal

One slot

(a)

One slot

(b)

FIG. 8

FIG. 9(a)

FIG. 9(b)

FIG. 10

FIG. 11

DPD coefficient of a 3$^{rd}$ segment

**Second device**

Pre-PA signal of the 3$^{rd}$ segment

x[n] → Power extraction module

DPD module #3

DPD module #2

Pre-PA signal of a 2$^{nd}$ segment

Pre-PA signal of a 1$^{st}$ segment

DPD module #1

× → PA → Antenna

PA → Antenna

... PA → Antenna

**First device**

Model extraction module #3

Pre-PA signal of the 3$^{rd}$ segment

Post-PA signal of the 3$^{rd}$ segment

Antenna → Processing module

Model extraction module #2

Power extraction module

Signal reconstruction module

Post-PA signal of a 2$^{nd}$ segment

Pre-PA signal of the 2$^{nd}$ segment

Model extraction module #1

Post-PA signal of a 1$^{st}$ segment

Pre-PA signal of the 1$^{st}$ segment

Output power

1$^{st}$ segment

2$^{nd}$ segment

3$^{rd}$ segment

Saturation point

Input power

FIG. 12

EP 4 580 072 A1

FIG. 13

FIG. 14

FIG. 15

Second device

Second device

First device
(for saturation point detection
and predistortion training)

First device #1
(for saturation point detection)

First device #2
(for predistortion training)

FIG. 16

Communication
apparatus

Transceiver unit
1701

Processing unit
1702

FIG. 17

Communication apparatus

Processor
1801

1804

Memory
1803

Communication
interface
1802

FIG. 18

## INTERNATIONAL SEARCH REPORT

| International application No. |
| --- |
| **PCT/CN2023/119680** |

| A. | CLASSIFICATION OF SUBJECT MATTER |
| --- | --- |

H04B 1/04(2006.01)i

According to International Patent Classification (IPC) or to both national classification and IPC

| B. | FIELDS SEARCHED |
| --- | --- |

Minimum documentation searched (classification system followed by classification symbols)

IPC: H04B，H04W

Documentation searched other than minimum documentation to the extent that such documents are included in the fields searched

Electronic data base consulted during the international search (name of data base and, where practicable, search terms used)

CNTXT, ENTXTC, WPABSC, DWPI: 功率放大, 预失真, 后失真, 失真, 系数, 包络, 区间, 范围, 功率, 参考, 配置, PA, pre-distortion, post-distortion, distortion, coefficient, envelope, interval, range, power, reference, configuration

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | WO 2022247655 A1 (HUAWEI TECHNOLOGIES CO., LTD.) 01 December 2022 (2022-12-01) <br> description, paragraphs 235-400 | 1-25 |
| A | CN 115021689 A (BEIJING LITONG COMMUNICATION CO., LTD.) 06 September 2022 (2022-09-06) <br> entire document | 1-25 |
| A | US 2019190552 A1 (QUALCOMM INC.) 20 June 2019 (2019-06-20) <br> entire document | 1-25 |
| A | US 2022345091 A1 (ZTE CORP.) 27 October 2022 (2022-10-27) <br> entire document | 1-25 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **22 November 2023** | **28 November 2023** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/119680**

| Patent document cited in search report | | | Publication date (day/month/year) | Patent family member(s) | | | Publication date (day/month/year) |
|---|---|---|---|---|---|---|---|
| WO | 2022247655 | A1 | 01 December 2022 | CN | 115413009 | A | 29 November 2022 |
| CN | 115021689 | A | 06 September 2022 | None | | | |
| US | 2019190552 | A1 | 20 June 2019 | KR | 20210010666 | A | 27 January 2021 |
| | | | | EP | 3729753 | A1 | 28 October 2020 |
| | | | | TW | 201929464 | A | 16 July 2019 |
| | | | | JP | 2020202568 | A | 17 December 2020 |
| | | | | WO | 2019126193 | A1 | 27 June 2019 |
| | | | | KR | 20200074245 | A | 24 June 2020 |
| | | | | JP | 2021507605 | A | 22 February 2021 |
| | | | | BR | 112020011956 | A2 | 17 November 2020 |
| | | | | EP | 4254885 | A2 | 04 October 2023 |
| | | | | US | 2020321992 | A1 | 08 October 2020 |
| | | | | CN | 111567001 | A | 21 August 2020 |
| | | | | SG | 11202004131 | A1 | 29 July 2020 |
| | | | | CN | 113595568 | A | 02 November 2021 |
| US | 2022345091 | A1 | 27 October 2022 | WO | 2021052376 | A1 | 25 March 2021 |
| | | | | AU | 2020348800 | A1 | 14 April 2022 |
| | | | | EP | 4016944 | A1 | 22 June 2022 |
| | | | | WO | 2019058307 | A1 | 28 March 2019 |
| | | | | CN | 111108469 | A | 05 May 2020 |
| | | | | US | 2020193943 | A1 | 18 June 2020 |
| | | | | EP | 3685255 | A1 | 29 July 2020 |
| | | | | CN | 112543156 | A | 23 March 2021 |

Form PCT/ISA/210 (patent family annex) (July 2022)

**EP 4 580 072 A1**

**Patent documents cited in the description**

- CN 202211168582